(19) Europäisches Patentamt
European Patent Office
Office européen des brevets

(11) **EP 1 888 735 B1**

(12) **EUROPEAN PATENT SPECIFICATION**

(45) Date of publication and mention of the grant of the patent:
**07.08.2013  Bulletin 2013/32**

(21) Application number: **06771152.3**

(22) Date of filing: **25.05.2006**

(51) Int Cl.:
*H01L 21/02* (2006.01)    *C11D 1/62* (2006.01)
*C11D 3/26* (2006.01)    *C11D 3/30* (2006.01)
*C11D 7/32* (2006.01)    *C11D 11/00* (2006.01)

(86) International application number:
**PCT/US2006/020214**

(87) International publication number:
**WO 2006/127885 (30.11.2006 Gazette 2006/48)**

(54) **COPPER PASSIVATING POST-CHEMICAL MECHANICAL POLISHING CLEANING COMPOSITION AND METHOD OF USE**

KUPFERPASSIVIERENDE, NACH DEM CHEMISCH-MECHANISCHEN POLIEREN ANZUWENDENDES REINIGUNGSMITTEL UND VERWENDUNG

COMPOSITION DE NETTOYAGE A POLISSAGE MECANIQUE POST-CHIMIQUE A PASSIVATION DE CUIVRE ET PROCEDE D'UTILISATION

(84) Designated Contracting States:
**AT BE BG CH CY CZ DE DK EE ES FI FR GB GR HU IE IS IT LI LT LU LV MC NL PL PT RO SE SI SK TR**

(30) Priority: **26.05.2005  US 684812 P**
**10.11.2005  US 736036 P**
**13.02.2006  US 773126 P**

(43) Date of publication of application:
**20.02.2008  Bulletin 2008/08**

(73) Proprietor: **ADVANCED TECHNOLOGY MATERIALS, INC.**
**Danbury, CT 06810 (US)**

(72) Inventors:
• **BARNES, Jeffrey**
**Bath, Pennsylvania 18014 (US)**

• **WALKER, Elizabeth,**
**Nazareth, Pennsylvania 18064 (US)**
• **PETERS, Darryl**
**Stewartsville, New Jersey 08886 (US)**
• **BARTOSH, Kyle**
**Northampton, Pennsylvania 18067 (US)**
• **OLDAK, Ewa**
**PL-16/27 Afykanska (PL)**
• **YANDERS, Kevin P.**
**Germansville, Pennsylvania 18053 (US)**

(74) Representative: **ABG Patentes, S.L.**
**Avenida de Burgos, 16D**
**Edificio Euromor**
**28036 Madrid (ES)**

(56) References cited:
**WO-A2-01/95381        WO-A2-02/065538**
**US-A1- 2003 130 146    US-B1- 6 194 366**
**US-B1- 6 492 308        US-B2- 6 797 682**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**FIELD OF THE INVENTION**

The present invention relates to alkaline aqueous compositions for cleaning post-chemical mechanical polishing (CMP) residue, post-etch residue and/or contaminants from microelectronic devices, wherein the aqueous cleaning compositions efficaciously remove post-CMP residue, post-etch residue and passivate metallic interconnect materials without damaging low-k dielectric material on the microelectronic device.

**DESCRIPTION OF THE RELATED ART**

As semiconductor device geometries continue to shrink to less than 0.18 $\mu$m, more emphasis has been placed on improved interconnect structures to minimize resistance-capacitance (RC) delays. Strategies to minimize interconnect delays include improving conductivity of the interconnect metal and lowering the dielectric constant (k) value of the dielectric layers. For example, copper has emerged as a replacement for conventional aluminum as the interconnect metal in advanced devices. Copper is more conductive than aluminum (thus reducing resistance-capacitance time delays) and also is less subject to electromigration when compared to conventional Al metallization.

In the manufacturing of deep submicron semiconductors, the copper damascene process is used to form a conductive copper line in the low-k dielectric layer. One important step of the damascene process is copper chemical mechanical polishing (CMP) for the removal of excess copper above the dielectric layer surface.

The CMP process involves holding and rotating a thin, flat substrate of the semiconductor device against a wetted polishing pad under controlled pressure and temperature in the presence of CMP slurries. The slurries contain abrasive materials and chemical additives as appropriate to the specific CMP process and requirements. Following the CMP process, contaminants consisting of particles from the polishing slurry, chemicals added to the slurry, and reaction by-products of the polishing slurry are left behind on the wafer surface. In addition, the polishing of a copper/low dielectric constant material on a silicon wafer often generates carbon-rich particles that settle onto the wafer surface. All contaminants must be removed prior to any further steps in the microelectronic device fabrication process to avoid introduction of defects into the device and degradation of device reliability. Often, particles of these contaminants are smaller than 0.3 $\mu$m.

Conventional wet techniques use fluid flow over the wafer surface to remove contaminants and as such, their efficiency is limited by the thickness of the boundary layer created by the fluid flow. A particle smaller than the boundary layer, e.g., sub-0.3 $\mu$m, is shielded from the physical drag force of the fluid and therefore remains on the wafer surface. Additional adhesion, due to chemical and hydrogen bonding, further complicates the cleaning capabilities of wet cleaning techniques and significantly reduces the efficiency of these processes for removing smaller sized contaminants.

Typically, the wet technique uses an aqueous cleaning solution, e.g., alkaline solutions based on ammonium hydroxide, in combination with some form of brushing, jetting or ultrasound. Aqueous cleaning solutions remove the contaminants by attacking the wafer surface or reacting with the contaminants before removing the dislodged contaminants from the wafer. Disadvantageously, some of the contaminants may be chemically inert to the chemical ingredients in the aqueous solution. For example, carbon-rich particles or chemical reaction by-products attached to the wafer may not be easily removed by the chemicals in the aqueous cleaning solution.

Megasonics may be used in conjunction with these conventional wet techniques to significantly reduce the boundary layer thickness. However, it is still not sufficient to efficiently remove sub-0.3 $\mu$m sized particles from the wafer surface.

The use of low-k dielectric films such as carbon-doped oxides or organic films in dual damascene integration has added a further challenge to post-CMP cleaning in which only aqueous-based chemistries are used. These films as well as CMP stop layers, such as silicon carbide, silicon nitride, and silicon oxynitride, are very hydrophobic and hence are difficult to clean with water-based cleaning solutions. In addition, because the carbon atoms within most types of neutral-to-acidic slurries have a potential opposite to that of the copper surface, the carbon-rich particles are likely to attach to the copper surface, producing additional surface defects.

Another residue-producing process common to microelectronic device manufacturing involves gas-phase plasma etching to transfer the patterns of developed photoresist coatings to the underlying layers, which may consist of hardmask, interlevel dielectric (ILD), and etch stop layers. Post-gas phase plasma etch residues, which may include chemical elements present on the substrate and in the plasma gases, are typically deposited on the back end of the line (BEOL) structures and if not removed, may interfere with subsequent silicidation or contact formation. Conventional cleaning chemistries often damage the ILD, absorb into the pores of the ILD thereby increasing the dielectric constant, and/or corrode the metal structures.

U.S. Patent No. 6,558,879 in the name of Peters et al. relates to stripping and cleaning compositions for the removal of residue from metal or dielectric surfaces in the manufacture of semiconductors and microcircuits. The compositions include water, an organic co-solvent and a corrosion inhibitor. Disadvantageously, the preferred solvent, N, N'-dimethylacetamide (DMAC) has poor acceptance in the semiconductor industry because it extracts carbon from the ultra-low-k dielectric materials, increasing the dielectric constant of said dielectric material.

Another common problem in microelectronic device manufacturing is the film-like residue that remains on the semiconductor device substrate following CMP processing. Such residue may include passivator compounds such as benzotriazole (BTA) see e.g. WO 01/95381 A2, US 619436681 and WO 02/065538 A2. If not removed, these residues can cause damage to copper lines or severely roughen the copper metallization, as well as cause poor adhesion of layers applied subsequent to the post-CMP removal process. Severe roughening of copper metallization is particularly problematic, since overly rough copper can cause poor electrical performance of the product semiconductor device.

It would be a significant advance in the art to provide improved aqueous compositions for post-CMP and/or post-etch cleaning of microelectronic devices, for the defect and scratch-free removal of CMP residue, post-etch residue and/or contaminants from the surface of said device. Preferably, said aqueous compositions effectuate substantial residue and contaminant removal from the surface of the device and passivate the exposed interconnect materials, e.g., copper, without damaging low-k dielectric material.

## SUMMARY OF THE INVENTION

The present invention generally relates to alkaline aqueous compositions in accordance with claim 1 and process for cleaning post-CMP residue, post-etch residue and/or contaminants from microelectronic devices having said residue and/or contaminants thereon, while simultaneously passivating the metallic interconnect materials on the microelectronic device surface.

The formulations of the present invention in accordance with claim 1 comprise at least one amine, at least one passivating agent, at least one quaternary base, optionally at least one reducing agent, and the balance water. In a further alternative embodiment, the formulations of the present invention comprise at least one amine, at least one passivating agent, at least one quaternary base, at least one reducing agent, optionally at least one surfactant, and the balance water. In a still further alternative embodiment, the formulations of the present invention comprise at least one amine, at least one passivating agent, at least one quaternary base, optionally at least one complexing agent, and the balance water.

In a particularly preferred embodiment: the range of ratios for amine(s) relative to passivating agent(s) is (2 to 25):(0.05 to 15); the range of ratios for amine(s) relative to complexing agent(s) (when present) is (2 to 25):(0.001 to 25); the range of ratios for amine(s) relative to reducing agent(s) (when present) is (2 to 25):(0.001 to 25); the range of ratios for amine(s) relative to quaternary base(s) (when present) is (2 to 25):(0.001 to 10); and the range of ratios for amine(s) relative to surfactant(s) (when present) is (2 to 25):(0.001 to 1); and the balance water.

The invention relates to an alkaline aqueous cleaning composition in accordance with claim 1, comprising at least one amine, at least one passivating agent, at least one quaternary base, optionally at least one reducing agent, and water, wherein said alkaline aqueous cleaning composition is suitable for cleaning residue and contaminants from a microelectronic device having said residue and contaminants thereon. Optionally, the alkaline aqueous cleaning composition may further comprise at least one surfactant. Preferably, the alkaline aqueous cleaning composition comprises at least one reducing agent, and said reducing agent comprises ascorbic acid.

In another aspect, the present invention relates to a kit comprising, in one or more containers, one or more reagents for forming an alkaline aqueous cleaning composition in accordance with claim 1, said one or more reagents selected from the group consisting of at least one amine, at least one passivating agent, at least one quaternary base, optionally at least one reducing agent, and water, and wherein the kit is adapted to form an alkaline aqueous cleaning composition suitable for cleaning material from a microelectronic device, wherein the material is selected from the group consisting of post-CMP residue, post-gas phase plasma etching residue, and contaminants thereof. Optionally, the alkaline aqueous cleaning compositions may further comprise at least one surfactant. Preferably, the alkaline aqueous cleaning composition comprises at least one reducing agent, and said reducing agent comprises ascorbic acid.

In yet another aspect, the present invention relates to a method of cleaning residue and contaminants from a microelectronic device having said residue and contaminants thereon, said method comprising contacting the microelectronic device with an alkaline aqueous cleaning composition in accordance with claim 1 for sufficient time to at least partially clean said residue and contaminants from the microelectronic device, wherein the alkaline aqueous cleaning composition includes at least one amine, at least one passivating agent, at least one quaternary base, optionally at least one reducing agent, and water. Optionally, the alkaline aqueous cleaning compositions may further comprise at least one surfactant. Preferably, the alkaline aqueous cleaning composition comprises at least one reducing agent, and said reducing agent comprises ascorbic acid.

Other aspects, features and advantages of the invention will be more fully apparent from the ensuing disclosure and appended claims.

## BRIEF DESCRIPTION OF THE DRAWINGS

Figure 1 illustrates the proposed undercutting and lifting-off mechanism for the removal of post-CMP residue and contaminants from the surface of a microelectronic device.

Figure 2 illustrates the thickness of the blanketed copper wafer as a function of time following immersion in formulations AA-AF.

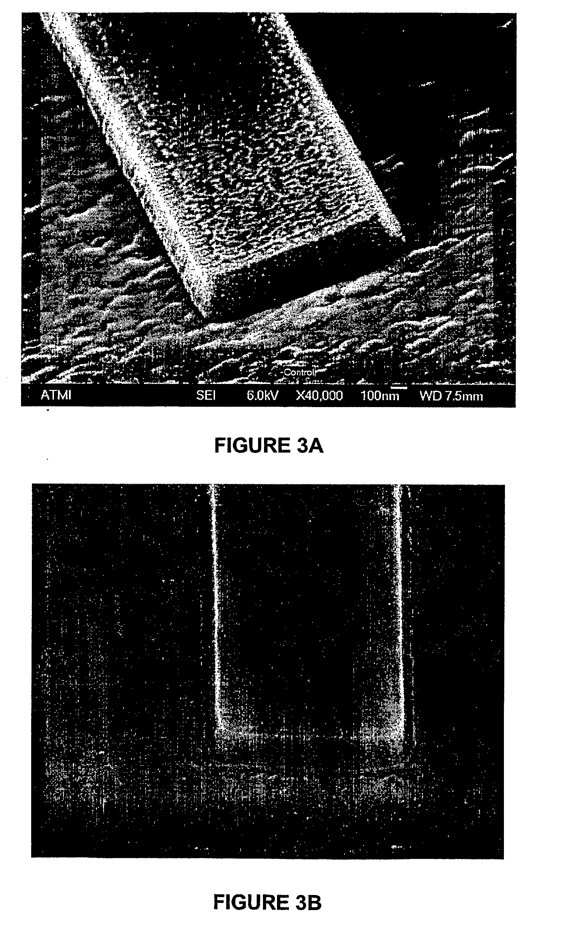

Figure 3A is an electron micrograph of a control wafer before immersion in Formulation AC.

Figure 3B is an electron micrograph of the control wafer of Figure 3A after immersion in Formulation AC.

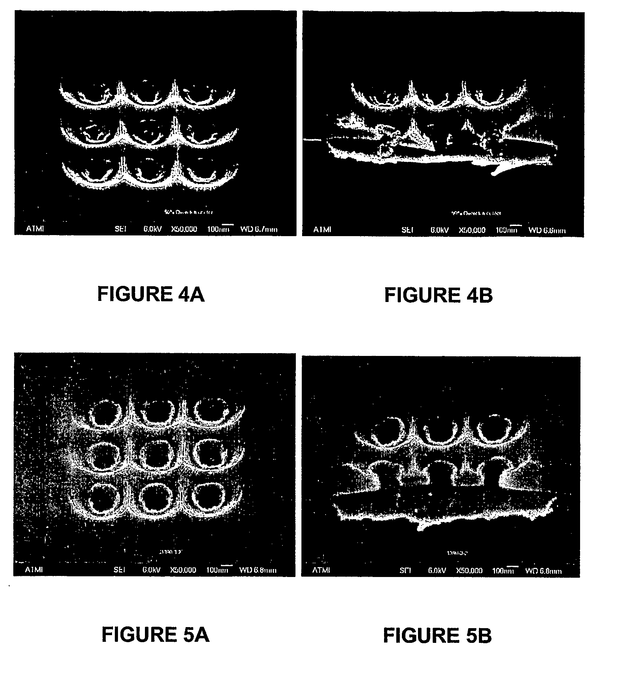

Figure 4A is an electron micrograph of a post via-barrier breakthrough wafer prior to immersion in Formulation AC.

Figure 4B is an electron micrograph of a cleaved post via-barrier breakthrough wafer prior to immersion in Formulation AC.

Figure 5A is an electron micrograph of a post via-barrier breakthrough wafer subsequent to immersion in Formulation AC.

Figure 5B is an electron micrograph of a post via-barrier breakthrough wafer subsequent to immersion in Formulation AC.

Figure 6 illustrates the surface energy and contact angle of DI water on various treated and untreated copper surfaces.

Figure 7 illustrates the mass of a copper electrode of a quartz crystal microbalance (QCM) immersed in DI water at natural pH as a function of time.

Figure 8 illustrates the mass of a copper electrode of a QCM immersed in a 0.058 wt. % TAZ solution at pH 5.8 as a function of time.

Figure 9 illustrates the open circuit potential (OCP) for a copper electrode immersed in a 0.058 wt. % TAZ solution at pH 5.8 as a function of time.

Figure 10 illustrates the mass of a copper electrode of a QCM immersed in DI water adjusted to pH 11.5 as a function of time.

Figure 11 illustrates the OCP for a copper electrode immersed in a 0.058 wt. % TAZ solution at pH 11.5 as a function of time.

Figure 12 illustrates the OCP for a BTA-treated copper electrode immersed in a 0.1 wt. % TAZ solution at pH 11.5 as a function of time.

Figure 13 illustrates the mass of a copper electrode of a QCM for a BTA-treated copper electrode immersed in a 0.1 wt. % TAZ solution at pH 11.5 as a function of time.

Figure 14 illustrates the number of defects on copper, TEOS, Coral and Black Diamond following post-CMP cleaning according to two different cleaning methodologies.

Figure 15 illustrates the number of defects as a function of time for a blanketed copper wafer following a rinse-buff during the CMP buff step with a 10:1 dilution of formulation BF (with DI water) followed by post-CMP cleaning in a brush box using a 30:1 dilution of a concentrated composition including 4.7% TMAH, 20.6% TEA, 3.3% gallic acid, 11.2% ascorbic acid and the balance water.

Figure 16A is a micrograph of a CMP contaminated Sematech 854 control wafer at the edge of a bond pad at a magnification of 30,000x.

Figure 16B is a micrograph of a CMP contaminated Sematech 854 control wafer at a randomly selected bond pad at a magnification of 6,000x.

Figure 17A is a micrograph of a CMP contaminated Sematech 854 control wafer at the center of a bond pad at a magnification of 30,000x following spin/spray treatment in a 60:1 dilution (with DI water) of formulation BH for 60 sec at 22°C.

Figure 17B is a micrograph of a CMP contaminated Sematech 854 control wafer at the edge of a bond pad at a magnification of 30,000x following spin/spray treatment in a 60:1 dilution (with DI water) of formulation BH for 60 sec at 22°C.

Figure 17C is a micrograph of a CMP contaminated Sematech 854 control wafer at a randomly selected bond pad at a magnification of 6,000x following spin/spray treatment in a 60:1 dilution (with DI water) of formulation BH for 60 sec at 22°C.

Figure 17D is a micrograph of a CMP contaminated Sematech 854 control wafer at an area of the $0.18\mu$m line pattern at a magnification of 6,000x following spin/spray treatment in a 60:1 dilution (with DI water) of formulation BH for 60 sec at 22°C.

Figure 18A is a micrograph of a CMP contaminated Sematech 854 control wafer at the center of a bond pad at a magnification of 30,000x following spin/spray treatment in a 60:1 dilution (with DI water) of formulation BI for 60 sec at 22°C.

Figure 18B is a micrograph of a CMP contaminated Sematech 854 control wafer at the edge of a bond pad at a magnification of 30,000x following spin/spray treatment in a 60:1 dilution (with DI water) of formulation BI for 60 sec at 22°C.

Figure 18C is a micrograph of a CMP contaminated Sematech 854 control wafer at a randomly selected bond pad at a magnification of 6,000x following spin/spray treatment in a 60:1 dilution (with DI water) of formulation BI for 60 sec at 22°C.

Figure 18D is a micrograph of a CMP contaminated Sematech 854 control wafer at an area of the $0.18\mu m$ line pattern at a magnification of 6,000x following spin/spray treatment in a 60:1 dilution (with DI water) of formulation BI for 60 sec at 22°C.

Figure 19A is a micrograph of a CMP contaminated Sematech 854 control wafer at the center of a bond pad at a magnification of 30,000x following spin/spray treatment in a 60:1 dilution (with DI water) of formulation BJ for 60 sec at 22°C.

Figure 19B is a micrograph of a CMP contaminated Sematech 854 control wafer at the edge of a bond pad at a magnification of 30,000x following spin/spray treatment in a 60:1 dilution (with DI water) of formulation BJ for 60 sec at 22°C.

Figure 19C is a micrograph of a CMP contaminated Sematech 854 control wafer at a randomly selected bond pad at a magnification of 6,000x following spin/spray treatment in a 60:1 dilution (with DI water) of formulation BJ for 60 sec at 22°C.

Figure 19D is a micrograph of a CMP contaminated Sematech 854 control wafer at an area of the 0.18 $\mu m$ line pattern at a magnification of 6,000x following spin/spray treatment in a 60:1 dilution (with DI water) of formulation BJ for 60 sec at 22°C.

Figure 20A is a micrograph of a CMP contaminated Sematech 854 control wafer at the center of a bond pad at a magnification of 30,000x following spin/spray treatment in a 60:1 dilution (with DI water) of formulation BK for 60 sec at 22°C.

Figure 20B is a micrograph of a CMP contaminated Sematech 854 control wafer at the edge of a bond pad at a magnification of 30,000x following spin/spray treatment in a 60:1 dilution (with DI water) of formulation BK for 60 sec at 22°C.

Figure 20C is a micrograph of a CMP contaminated Sematech 854 control wafer at a randomly selected bond pad at a magnification of 6,000x following spin/spray treatment in a 60:1 dilution (with DI water) of formulation BK for 60 sec at 22°C.

Figure 20D is a micrograph of a CMP contaminated Sematech 854 control wafer at an area of the $0.18\mu m$ line pattern at a magnification of 6,000x following spin/spray treatment in a 60:1 1 dilution (with DI water) of formulation BK for 60 sec at 22°C.

Figure 21A is a micrograph of a CMP contaminated Sematech 854 control wafer at the center of a bond pad at a magnification of 30,000x following spin/spray treatment in a 60:1 dilution (with DI water) of formulation BL for 60 sec at 22°C.

Figure 21B is a micrograph of a CMP contaminated Sematech 854 control wafer at the edge of a bond pad at a magnification of 30,000x following spin/spray treatment in a 60:1 dilution (with DI water) of formulation BL for 60 sec at 22°C.

Figure 21C is a micrograph of a CMP contaminated Sematech 854 control wafer at a randomly selected bond pad at a magnification of 6,000x following spin/spray treatment in a 60:1 dilution (with DI water) of formulation BL for 60 sec at 22°C.

Figure 21D is a micrograph of a CMP contaminated Sematech 854 control wafer at an area of the 0.18 $\mu m$ line pattern at a magnification of 6,000x following spin/spray treatment in a 60:1 dilution (with DI water) of formulation BL for 60 sec at 22°C.

Figure 22A is a micrograph of a CMP contaminated Sematech 854 control wafer at the center of a bond pad at a magnification of 30,000x following spin/spray treatment in a 60:1 dilution (with DI water) of formulation BM for 60 sec at 22°C.

Figure 22B is a micrograph of a CMP contaminated Sematech 854 control wafer at the edge of a bond pad at a magnification of 30,000x following spin/spray treatment in a 60:1 dilution (with DI water) of formulation BM for 60 sec at 22°C.

Figure 22C is a micrograph of a CMP contaminated Sematech 854 control wafer at a randomly selected bond pad at a magnification of 6,000x following spin/spray treatment in a 60:1 dilution (with DI water) of formulation BM for 60 sec at 22°C.

Figure 22D is a micrograph of a CMP contaminated Sematech 854 control wafer at an area of the $0.18\mu m$ line pattern at a magnification of 6,000x following spin/spray treatment in a 60:1 dilution (with DI water) of formulation BM for 60 sec at 22°C.

Figure 23A is a micrograph of a CMP contaminated Sematech 854 control wafer at the center of a bond pad at a magnification of 30,000x following spin/spray treatment in a 60: Dilution (with DI water) of formulation BF for 60 sec at 22°C.

Figure 23B is a micrograph of a CMP contaminated Sematech 854 control wafer at the edge of a bond pad at a magnification of 30,000x following spin/spray treatment in a 60:1 dilution (with DI water) of formulation BF for 60 sec at 22°C.

Figure 23C is a micrograph of a CMP contaminated Sematech 854 control wafer at a randomly selected bond pad at a magnification of 6,000x following spin/spray treatment in a 60:1 dilution (with DI water) of formulation BF for 60 sec at 22°C.

Figure 23D is a micrograph of a CMP contaminated Sematech 854 control wafer at an area of the $0.18\mu m$ line pattern at a magnification of 6,000x following spin/spray treatment in a 60:1 dilution (with DI water) of formulation BF for 60 sec at 22°C.

Figure 24A is a micrograph of a CMP contaminated Sematech 854 control wafer at the center of a bond pad at a magnification of 30,000x following spin/spray treatment in a 60:1 dilution (with DI water) of formulation BN for 60 sec at 22°C.

Figure 24B is a micrograph of a CMP contaminated Sematech 854 control wafer at the edge of a bond pad at a magnification of 30,000x following spin/spray treatment in a 60:1 dilution (with DI water) of formulation BN for 60 sec at 22°C.

Figure 24C is a micrograph of a CMP contaminated Sematech 854 control wafer at a randomly selected bond pad at a magnification of 6,000x following spin/spray treatment in a 60:1 dilution (with DI water) of formulation BN for 60 sec at 22°C.

Figure 24D is a micrograph of a CMP contaminated Sematech 854 control wafer at an area of the $0.18 \mu m$ line pattern at a magnification of 6,000x following spin/spray treatment in a 60:1 dilution (with DI water) of formulation BN for 60 sec at 22°C.

Figure 25A is a micrograph of a CMP contaminated Sematech 854 control wafer at the center of a bond pad at a magnification of 30,000x following spin/spray treatment in a 60:1 dilution (with DI water) of formulation BO for 60 sec at 22°C.

Figure 25B is a micrograph of a CMP contaminated Sematech 854 control wafer at the edge of a bond pad at a magnification of 30,000x following spin/spray treatment in a 60:1 dilution (with DI water) of formulation BO for 60 sec at 22°C.

Figure 25C is a micrograph of a CMP contaminated Sematech 854 control wafer at a randomly selected bond pad at a magnification of 6,000x following spin/spray treatment in a 60:1 dilution (with DI water) of formulation BO for 60 sec at 22°C.

Figure 25D is a micrograph of a CMP contaminated Sematech 854 control wafer at an area of the $0.18\mu m$ line pattern at a magnification of 6,000x following spin/spray treatment in a 60:1 dilution (with DI water) of formulation BO for 60 sec at 22°C.

Figure 26A is a micrograph of a CMP contaminated Sematech 854 control wafer at the center of a bond pad at a magnification of 30,000x following spin/spray treatment in a 60:1 dilution (with DI water) of formulation BP for 60 sec at 22°C.

Figure 26B is a micrograph of a CMP contaminated Sematech 854 control wafer at the edge of a bond pad at a magnification of 30,000x following spin/spray treatment in a 60:1 dilution (with DI water) of formulation BP for 60 sec at 22°C.

Figure 26C is a micrograph of a CMP contaminated Sematech 854 control wafer at a randomly selected bond pad at a magnification of 6,000x following spin/spray treatment in a 60:1 dilution (with DI water) of formulation BP for 60 sec at 22°C.

Figure 26D is a micrograph of a CMP contaminated Sematech 854 control wafer at an area of the $0.18\mu m$ line pattern at a magnification of 6,000x following spin/spray treatment in a 60:1 dilution (with DI water) of formulation BP for 60 sec at 22°C.

Figure 27A is an optical image of the contact angle of diluted Formulation BR on a dielectric surface.

Figure 27B is an optical image of the contact angle of diluted Formulation BS on a dielectric surface.

Figure 28 is an atomic force microscopy (AFM) image of a Sematech 854 wafer before and after cleaning the wafer with formulation EC of the present invention.

Figure 29 is an AFM image of a Sematech 854 wafer before and after cleaning the wafer with formulation EF of the present invention.

Figure 30 illustrates the nitrogen to copper ratio, and hence the relative thickness of the copper passivating film, using formulations of the present invention.

## DETAILED DESCRIPTION OF THE INVENTION, AND PREFERRED EMBODIMENTS THEREOF

The present invention relates to alkaline aqueous compositions that clean post-CMP residue, post-etch residue and/or contaminants from a microelectronic device having such material(s) thereon, said compositions having high selectivity for the residue/contaminant material while simultaneously passivating the metallic interconnect materials, e.g., copper and cobalt, on the microelectronic device.

For ease of reference, "microelectronic device" corresponds to semiconductor substrates, flat panel displays, and microelectromechanical systems (MEMS), manufactured for use in microelectronic, integrated circuit, or computer chip applications. It is to be understood that the term "microelectronic device" is not meant to be limiting in any way and includes any substrate that will eventually become a microelectronic device or microelectronic assembly.

As used herein, "post-CMP residue" corresponds to particles from the polishing slurry, carbon-rich particles, polishing pad particles, brush deloading particles, equipment materials of construction particles, copper, copper oxides, and any other materials that are the by-products of the CMP process.

As used herein, "contaminants" correspond to chemicals present in the CMP slurry, reaction by-products of the polishing slurry, and any other materials that are the by-products of the CMP process.

As defmed herein, "low-k dielectric material" corresponds to any material used as a dielectric material in a layered microelectronic device, wherein the material has a dielectric constant less than about 3.5. Preferably, the low-k dielectric materials include low-polarity materials such as silicon-containing organic polymers, silicon-containing hybrid organic/inorganic materials, organosilicate glass (OSG), TEOS, fluorinated silicate glass (FSG), silicon dioxide, and carbon-doped oxide (CDO) glass. It is to be appreciated that the low-k dielectric materials may have varying densities and varying porosities.

As defined herein, "post-etch residue" corresponds to material remaining following gas-phase plasma etching processes, e.g., BEOL dual damascene processing. The post-etch residue may be organic, organometallic, organosilicic, or inorganic in nature, for example, silicon-containing material, carbon-based organic material, and etch gas residue including, but not limited to, oxygen and fluorine.

As used herein, "about" is intended to correspond to $\pm$ 5 % of the stated value.

As used herein, "suitability" for cleaning residue and contaminants from a microelectronic device having said residue and contaminants thereon corresponds to at least partial removal of said residue/contaminants from the microelectronic device. Preferably, at least 85% of the residue/ontaminants is removed from the microelectronic device using the compositions of the invention, more preferably at least 90%, even more preferably at least 95%, and most preferably at least 99% of the residue/contaminants is removed.

As defined herein, "complexing agent" includes those compounds that are understood by one skilled in the art to be complexing agents, chelating agents and/or sequestering agents. Complexing agents will chemically combine with or physically hold the metal atom and/or metal ion to be removed using the compositions of the present invention.

Importantly, the aqueous compositions of the present invention must possess good metal compatibility, e.g., a low etch rate on the interconnect metal and/or interconnector metal silicide material. Metals of interest include, but are not limited to, copper, tungsten, cobalt, aluminum, tantalum, titanium and ruthenium.

Compositions of the invention may be embodied in a wide variety of specific formulations, as hereinafter more fully described.

In all such compositions, wherein specific components of the composition are discussed in reference to weight percentage ranges including a zero lower limit, it will be understood that such components may be present or absent in various specific embodiments of the composition, and that in instances where such components are present, they may be present at concentrations as low as 0.001 weight percent, based on the total weight of the composition in which such components are employed.

**Post-Etch Residue Removal Composition**

In one aspect, the present invention relates to an aqueous post-etch residue removal composition useful in removing post-etch residue from a microelectronic device having exposed metal and metal alloy materials, e.g., copper interconnects. According to one embodiment, the aqueous post-etch residue removal composition comprises at least one amine, at least one passivating agent, at least one quaternary base, optionally at least one complexing agent, and the balance water, present in the following ranges, based on the total weight of the composition.

| component | % by weight |
|---|---|
| quaternary base(s) | about 0.001 % to about 20% |
| amine(s) | about 0.001% to about 25% |
| passivating agent(s) | about 0.001% to about 5% |
| complexing agent(s) | 0 to about 10% |

(continued)

| component | % by weight |
| --- | --- |
| water | balance |

When the composition comprises complexing agent(s) the amount of complexing agent(s) is in a range from about 0.001 % to 10 wt. %, based on the total weight of the composition.

In the broad practice of the invention, the aqueous post-etch residue removal composition comprises, consists of, or consists essentially of quaternary base(s), amine(s), passivating agent(s), optional complexing agent(s), and water. The water is preferably deionized.

Preferably, the components in the concentrated aqueous post-etch residue removal composition are present in the following ranges, based on the total weight of the composition: about 0.01 to about 10% quaternary base(s) (when present), about 1 % to about 15% amine(s), about 0.001% to about 1% passivating agent(s), about 0.01% to about 5% complexing agent(s) (when present), and the balance DI water.

The compositions of the present invention may have utility in applications including, but not limited to, post-etch residue removal, surface preparation, post-plating cleaning and post-CMP residue removal.

Importantly, the dielectric material, including low-k dielectric material such as OSG, and the exposed metal and metal alloymaterials, e.g., copper, cobalt, tungsten, aluminum, etc., on the microelectronic device are not compromised by the aqueous post-etch residue removal composition. Preferably, the etch rate of copper material is in a range from about 0.5 Å min$^{-1}$ to about 10 Å min$^{-1}$, more preferably about 0.5 Å min$^{-1}$ to about 5 Å min$^{-1}$.

The aqueous post-etch residue removal compositions of the invention are preferably devoid of oxygen scavengers such as gallic acid and ascorbic acid. With the elimination of said oxygen scavengers, which oxidize over time in environments susceptible to redox reactions, the formulations have an extended pot-life with less variation of removal performance. The copper surface is passivated by the passivating agent(s) in the aqueous post-etch residue removal composition thereby minimizing copper roughening, and lowering the copper etch rates and concomitantly the copper corrosion. A secondary advantage of the aqueous post-etch residue removal compositions of the present invention is the elimination of separate post-removal BTA applications as well as a copper passivation layer that is easier to remove than a BTA layer thereby reducing the cost of ownership.

In the broad practice of the invention, the pH range of the aqueous post-etch residue removal composition is greater than about 11, more preferably in a range from about 11 to about 15.

The amine compounds may be primary or secondary amines and are selected from the group consisting of monoethanolamine (MEA), N-methylethanolamine (NMEA), aminoethylethanolamine, N-methylaminoethanol, aminoethoxyethanol, diethanolamine, 1-amino-2-propanol, monoisopropanolamine, isobutanolamine, $C_2$ - $C_8$ alkanolamines, triethylenediamine, and combinations thereof. Preferably, the amine compound includes monoethanolamine.

The term passivating agent, as used herein, is intended to mean any substance that reacts with the fresh copper surface and/or oxidized copper thin film to passivate, or protect, the copper-containing layer. The passivating agent in the aqueous post-etch residue removal composition of the invention comprises one or more components selected from 1,2,4-triazole (TAZ), tolyltriazole, 3-amino-5-mercapto-1,2,4-triazole, 1-amino-1,2,4-triazole, 1-amino-1,2,3-triazole, 1-amino-5-methyl-1,2,3-triazole, 3-amino-1,2,4-triazole, 3-mercapto-1,2,4-triazole, 3-isopropyl-1,2,4-triazole, naphthotriazole, thiazole, imidazole, 2-mercaptobenzimidazole (MBI), 2-mercaptobenzothiazole, 4-methyl-2-phenylimidazole, 2-mercaptothiazoline, 5-aminotetrazole, 5-amino-1,3,4-thiadiazole-2-thiol, 2,4-diamino-6-methyl-1,3,5-triazine, thiazole, triazine, methyltetrazole, 1,3-dimethyl-2-imidazolidinone, 1,5-pentamethylenetetrazole, 1-phenyl-5-mercaptotetrazole, diaminomethyltriazine, imidazoline thione, mercaptobenzimidazole, 4-methyl-4H-1,2,4-triazole-3-thiol, 5-amino-1,3,4-thiadiazole-2-thiol, benzothiazole, tritolyl phosphate, imidazole, indiazole. Further contemplated passivating agents for the aqueous post-etch residue removal composition include benzoic acid and ammonium benzoate. Preferably, the passivating agent includes TAZ, MBI, and combinations thereof

The optional quaternary bases contemplated herein include, but are not limited to, $(NR^1R^2R^3R^4)OH$ where $R^1$, $R^2$, $R^3$ and $R^4$ may be the same as or different from one another and each is independently selected from the group consisting of hydrogen, straight-chained or branched $C_1$-$C_{10}$ alkyl groups, and substituted and unsubstituted aryl groups. Quaternary bases contemplated include choline, tetrabutylammoniumhydroxide, tetraethylammonium hydroxide, tetramethylammonium hydroxide, tetrapropylammoniumhydroxide, and combinations thereof. Preferably, the quaternary base includes tetramethylammonium hydroxide (TMAH).

The complexing agents contemplated herein must be capable of combining with metals and/or metal ions at high solution pH to assist in the removal of said materials from the exposed dielectric surface. Complexing agents contemplated herein include acetic acid, acetone oxime, alanine, arginine, asparagine, aspartic acid, benzoic acid, betaine, dimethyl glyoxime, fumaric acid, glutamic acid, glutamine, glutaric acid, glycerol, glycine, glycolic acid, glyoxylic acid, histadine, iminodiacetic acid, isophthalic acid, itaconic acid, lactic acid, leucine, lysine, maleic acid, malic acid, malonic acid, oxalic acid, 2,4-pentanedione, phenylacetic acid, phenylalanine, phthalic acid, proline, pyromellitic acid, quinic acid, serine, sorbitol, succinic acid, terephthalic acid, trimellitic acid, trimesic acid, tyrosine, valine, xylitol, derivatives of the foregoing amino acids, and combinations thereof, with the provision that the complexing agent does not include citric acid. Other complexing agents contemplated herein include polyethylene ethers (PEGs), glycol ethers such as diethylene glycol monomethyl ether (methyl carbitol), triethylene glycol monomethyl ether, diethylene glycol monoethyl ether, triethylene glycol monoethyl ether, ethylene glycol monopropyl ether, ethylene glycol monobutyl ether, diethylene glycol monobutyl ether (butyl carbitol), triethylene glycol monobutyl ether, ethylene glycol monohexyl ether, diethylene glycol monohexyl ether, ethylene glycol phenyl ether, propylene glycol methyl ether, dipropylene glycol methyl ether, tripropylene glycol methyl ether (TPGME), propylene glycol n-propyl ether, dipropylene glycol n-propyl ether (DPGPE), tripropylene glycol n-propyl ether, propylene glycol n-butyl ether, dipropylene glycol n-butyl ether (DPGBE), tripropylene glycol n-butyl ether, propylene glycol phenyl ether (phenoxy-2-propanol) and combinations thereof. Preferably, the complexing agent includes lactic acid.

The aqueous post-etch removal composition of the invention does not require a surfactant in the formulation, however this does not preclude the use of surfactants in removal solutions of the invention in specific applications where such agents may be beneficial. For example, tridecylbenzenesulfonic acid (TSA-99) may be added to the aqueous post-etch removal compositions of the invention.

In addition, the aqueous post-CMP cleaning composition may further include oxidizing agent(s), co-solvent(s), etchant(s), defoamer(s), additional pH adjusting agent(s), etc. Co-solvents may be added to aid in organic resist removal.

In a preferred embodiment, the aqueous post-etch residue removal composition of the invention includes monoethanolamine, TMAH, lactic acid and MBI.

In another embodiment, the aqueous post-etch residue removal composition comprises at least one amine, at least one passivating agent, post-etch residue, optionally at least one quaternary base, optionally at least one complexing agent, optionally at least one surfactant, and the balance water. Importantly, the post-etch residue may be dissolved and/or suspended in the removal composition of the invention.

Importantly, the aqueous post-etch residue removal composition of the present invention has a significantly lower surface tension relative to deionized water. This enhances the ability of the aqueous composition of the invention to clean the post-etch residue and contaminants from the device surface.

In one embodiment of the invention, a concentrated aqueous post-etch residue removal composition is provided that can be diluted for use as a removal solution. A concentrated composition, or "concentrate," advantageously permits a user to dilute the concentrate to the desired strength and alkalinity at the point of use. Moreover, the concentrate of the product has a longer shelf life and is easier to ship and store. Dilution of the concentrated cleaning composition may be in a range from about 1:1 to about 200:1, wherein the cleaning composition is diluted at or just before the tool with solvent, e.g., deionized water. Preferably, the concentrated cleaning composition is diluted in a range from about 5:1 to about 50:1.

An important feature of the aqueous post-etch residue removal composition of the invention is that the non-aqueous constituents (the constituents other than water) are present in the composition in small quantities, preferably less than about 30 % by weight. This is an economic advantage since an effective removal composition can be formulated more economically, which is of importance since post-etch residue removal compositions are used in large quantities. Furthermore, because the removal composition is water-based, the removal compositions of the invention are more easily disposed of.

The aqueous post-etch residue removal compositions of the invention are easily formulated by simple addition of the respective ingredients and mixing to homogeneous condition. Furthermore, the aqueous post-etch residue removal compositions may be readily formulated as single-package formulations or multi-part formulations that are mixed at or before the point of use, e.g., the individual parts of the multi-part formulation may be mixed at the tool or in a storage tank upstream of the tool. The concentrations of the respective ingredients may be widely varied in specific multiples of the aqueous post-etch residue removal composition, i.e., more dilute or more concentrated, in the broad practice of the invention, and it will be appreciated that the aqueous post-etch residue removal compositions of the invention can variously and alternatively comprise, consist or consist essentially of any combination of ingredients consistent with the disclosure herein.

Accordingly, another aspect of the invention relates to a kit including, in one or more containers, two or more components adapted to form the compositions of the invention. Preferably, the kit includes, in one or more containers, at least one amine, and at least one passivating agent, for combining with water at the fab or the point of use. In an alternative embodiment, the kit includes, in one or more containers, at least one amine, at least one passivating agent, optionally at least one complexing agent, and optionally at least one quaternary base, for combining with water at the fab or the point of use. It will be appreciated by one skilled in the art that other combinations are contemplated herein.

In addition to an aqueous solution, it is also contemplated herein that the aqueous post-etch residue removal compositions may be formulated as foams, fogs, subcritical or supercritical fluids (i.e., wherein the solvent is $CO_2$, etc.,

instead of water).

As applied to microelectronic manufacturing operations, the aqueous post-etch residue removal compositions of the present invention are usefully employed to clean post-etch residue from the surface of the microelectronic device, while simultaneously passivating the metallic interconnect materials. Importantly, the removal compositions of the invention do not damage low-k dielectric materials on the device surface and preferably remove at least 85 % of the residue present on the device prior to residue removal, more preferably at least 90 %, even more preferably at least 95 %, and most preferred at least 99 %.

In post-etch removal application, the removal composition is applied in any suitable manner to the device to be cleaned, e.g., by spraying the removal composition on the surface of the device to be cleaned, by dipping (in a volume of the removal composition) the device to be cleaned, by contacting the device to be cleaned with another material, e.g., a pad, or fibrous sorbent applicator element, that is saturated with the removal composition, or by any other suitable means, manner or technique by which the removal composition is brought into removal contact with the device to be cleaned. Further, batch or single wafer processing is contemplated herein.

In use of the compositions of the invention for cleaning post-etch residue from microelectronic devices having same thereon, the aqueous post-etch residue removal composition typically is contacted with the device for a time of from about 30 sec to about 20 minutes, preferably about 2 min, at temperature in a range of from about 20°C to about 50°C. Such contacting times and temperatures are illustrative, and any other suitable time and temperature conditions may be employed that are efficacious to at least partially clean the post-etch residue/contaminants from the device, within the broad practice of the invention. "At least partially clean" corresponds to at removal of at least 85 % of the residue present on the device prior to residue removal, more preferably at least 90 %, even more preferably at least 95 %, and most preferred at least 99 %.

As applied to microelectronic manufacturing operations, the aqueous post-etch residue removal compositions of the present invention are usefully employed to clean post-CMP residue from the surface of the microelectronic device, while simultaneously passivating the metallic interconnect materials. Importantly, the cleaning compositions of the invention do not damage low-k dielectric materials on the device surface and preferably remove at least 85 % of the residue present on the device prior to residue removal, more preferably at least 90 %, even more preferably at least 95 %, and most preferred at least 99 %.

In the alternative post-CMP residue and contaminant cleaning application, the aqueous post-etch residue removal composition may be used with a large variety of conventional cleaning tools, including Verteq single wafer megasonic Goldfinger, OnTrak systems DDS (double-sided scrubbers), Laurell spin-spray tools, SEZ single wafer spray rinse, Applied Materials Mirra-Mesa™ /Reflexion ™/Reflexion LK™, and Megasonic batch wet bench systems.

In use of the compositions of the invention for cleaning post-CMP residue and contaminants from microelectronic devices having same thereon, the aqueous post-etch residue removal composition typically is contacted with the device for a time of from about 5 sec to about 10 minutes, preferably about 15 sec to 5 min, at temperature in a range of from about 20°C to about 50°C. Such contacting times and temperatures are illustrative, and any other suitable time and temperature conditions may be employed that are efficacious to at least partially clean the post-CMP residue/contaminants from the device, within the broad practice of the invention.

Following the achievement of the desired cleaning action, the aqueous post-etch residue removal composition may be readily removed from the device to which it has previously been applied, as may be desired and efficacious in a given end use application of the compositions of the present invention. Preferably, the rinse solution includes deionized water. Following the rinse process, the device may be dried using nitrogen or a spin-dry process.

## Post-CMP Cleaning Composition

In another aspect, the present invention relates to an aqueous post-CMP cleaning composition for cleaning post-CMP residue and contaminants from a microelectronic device having said residue and contaminants thereon, the formulations of the present invention comprise at least one amine, at least one passivating agent, at least one quaternary base, optionally at least one reducing agent, and the balance water, present in the following ranges, based on the total weight of the composition.

| component | % by weight |
| --- | --- |
| amine(s) | about 0.001% to about 25% |
| passivating agent(s) | about 0.001% to about 5% |
| quaternary base(s) | about 0.001 % to about 25% |
| reducing agent(s) | 0 to about 20% |

(continued)

| component | % by weight |
| --- | --- |
| water | balance |

In a further alternative embodiment, the formulations of the present invention comprise at least one amine, at least one passivating agent, at least one quaternary base, at least one reducing agent, optionally at least one surfactant, and the balance water, present in the following ranges, based on the total weight of the composition.

| component | % by weight |
| --- | --- |
| amine(s) | about 0.001% to about 25% |
| passivating agent(s) | about 0.001% to about 5% |
| quaternary base(s) | about 0.001% to about 25% |
| reducing agent(s) | about 0.001% to about 20% |
| surfactant(s) | 0 to about 5% |
| water | balance |

In the broad practice of the invention, the aqueous post-CMP cleaning composition may comprise, consist of, or consist essentially of amine(s), passivating agent(s), optional reducing agent(s), quaternary base(s), optional surfactant (s) and water, as described hereinabove. The water is preferably deionized.

In the broad practice of the invention, the pH range of the aqueous post-CMP cleaning composition is greater than about 9, most preferably in a range from about 10 to about 12.

The amine compounds may be primary or secondary amines and are selected from the group consisting of monoethanolamine (MEA), N-methylethanolamine (NMEA), aminoethylethanolamine, N-methylaminoethanol, aminoethoxyethanol, diethanolamine, 1-amino-2-propanol, monoisopropanolamine, isobutanolamine, $C_2 C_8$ alkanolamines, triethylenediamine, and combinations thereof. Preferably, the amine compound includes monoethanolamine or monoisopropanolamine. It is also contemplated herein that tertiary amines may be added to the aqueous post-CMP cleaning composition as a friction reducing agent in an amount from about 0.01 wt. % to about 20 wt. %, so long as some amount of primary and/or secondary amine is present. Tertiary amines contemplated include, but are not limited to, triethanolamine, methyldiethanolamine, triethylamine, N,N-dimethylglycolamine, N,N-dimethyldiglycolamine, and pentamethyldiethylenetriamine.

The term passivating agent, as used herein, is intended to mean any substance that reacts with the fresh copper surface and/or oxidized copper thin film to passivate, or protect, the copper-containing layer. Preferably, the passivating agent in the aqueous post-CMP cleaning composition of the invention may comprise one or more components enumerated hereinabove. More preferably, the passivating agent is 1,2,4-triazole.

The aqueous post-CMP cleaning compositions may optionally include reducing agent(s) selected from the group consisting of ascorbic acid, L(+)-ascorbic acid, isoascorbic acid, ascorbic acid derivatives, gallic acid, glyoxal, and combinations thereof.

The aqueous post-CMP cleaning compositions may optionally include quaternary bases including, but are not limited to, $(NR^1R^2R^3R^4)OH$ where $R^1$, $R^2$, $R^3$ and $R^4$ may be the same as or different from one another and each is independently selected from the group consisting of hydrogen, straight-chained or branched $C_1$-$C_{10}$ alkyl groups, and substituted or unsubstituted aryl groups. Preferably, the aqueous post-CMP cleaning composition comprises at least one quaternary base, said quaternary base preferably including tetramethylammonium hydroxide (TMAH).

The aqueous post-CMP cleaning compositions may optionally include surfactants. The surfactant(s) preferably are surface active agents which assist with dispersion/suspension, lowering liquid surface tensions, and lowering surface tensions between solids and liquids. In addition, it is hypothesized that the surfactant(s) also act as a surface modifying agent, increasing the viscosity of the formulation thereby reducing sheer stresses placed on the wafer. Surfactant(s) contemplated herein include, but are not limited to, nonionic surfactants, such as fluoroalkyl surfactants, polyethylene glycols, polypropylene glycols, polyethylene or polypropylene glycol ethers, carboxylic acid salts, dodecylbenzenesulfonic acid (DDBSA) or salts thereof, polyacrylate polymers, dinonylphenyl polyoxyethylene, silicone or modified silicone polymers, acetylenic diols or modified acetylenic diols, and alkylammonium or modified alkylammonium salts, hydroxyethylcellulose (500-35,000 MW), hydroxypropylcellulose (500-35,000 MW), methylhydroxypropylcellulose (500-35,000 MW), NATROSOL® 250 hydroxyethylcellulose, KLUCEL® EF hydroxypropylcellulose, as well as combinations comprising at least one of the foregoing surfactants. Alternatively, the surfactants may be a mixture of anionic and non-ionic surfactants. In a preferred embodiment, the surfactant is dodecylbenzenesulfonic acid, NATROSOL® and/or KLUCEL®.

In addition, the aqueous post-CMP cleaning composition may further include chelator(s), etchant(s), defoamer (s), pH adjusting agent(s), thickener(s) such as water-soluble high molecular weight compounds, etc.

Importantly, the dielectric material, including low-k dielectric material such as OSG, and the exposed metal and metal alloy materials, e.g., copper, cobalt, tungsten, aluminum, etc., on the microelectronic device are not compromised by the aqueous post-etch residue removal composition. Preferably, the etch rate of copper material is in a range from about 0.5 Å min$^{-1}$ to about 10 Å min$^{-1}$, more preferably about 0.5 Å min$^{-1}$ to about 5 Å min$^{-1}$.

Preferably, the components in the concentrated cleaning composition are present in the following ranges, based on the total weight of the composition, about 0.01% to about 62% amine(s), about 0.005% to about 25% reducing agent (s), about 0.005% to about 14% passivating agent(s), about 0.001 to about 25% quaternary base(s), and the balance water.

In a preferred embodiment, the aqueous post-CMP cleaning composition of the invention includes monoethanolamine, ascorbic acid, and TAZ.

In a particularly preferred embodiment, the aqueous post-CMP cleaning composition of the invention includes monoethanolamine, ascorbic acid, gallic acid, TMAH, and TAZ.

In another particularly preferred embodiment, the aqueous post-CMP cleaning composition of the invention includes monoethanolamine, gallic acid, TMAH, and TAZ.

In various embodiments, the aqueous post-CMP cleaning composition is formulated in the following Formulations BA-CM, some of which are preferred and some of which were prepared for comparison purposes, wherein all percentages are by weight, based on the total weight of the formulation:

Formulation BB MEA 7.2%, TMAH 4%, ascorbic acid 1.6%, TAZ 1%, gallic acid 2.8%, EDTA 0.01%, DI water 83.4%

Formulation BC MEA 7.2%, TMAH 4%, ascorbic acid 1.6%, TAZ 3%, gallic acid 2.8%, EDTA 0.01 %, DI water 81.4%

Formulation BD MEA 7.2%, TMAH 4%, ascorbic acid 1.6%, TAZ 5%, gallic acid 2.8%, EDTA 0.01%, DI water 74.4%, pH 10.3

Formulation BE MEA 8.8%, TMAH 4.9%, ascorbic acid 3.43%, TAZ 1.96%, DI water 80.91%

Formulation BF MEA 4.5%, TMAH 2.5%, ascorbic acid 1.75%, TAZ 1%, DI water 90.25%, pH 11.4

Formulation BG MEA 4.5%, TMAH 2.5%, ascorbic acid 1%, gallic acid 1.75%, TAZ 1%, DI water 89.25%, pH 10.8

Formulation BJ MEA 7.2%, TMAH 4%, ascorbic acid 1.6%, gallic acid 2.8%, carboxy BTA 2.2%, EDTA 0.01%, DI water 82.8%

Formulation BL MEA 7.2%, TMAH 4%, ascorbic acid 1.6%, gallic acid 2.8%, ATA 1.2%, EDTA 0.01%, DI water 83.2%

Formulation BN MEA 9%, TMAH 2.5%, ascorbic acid 3.5%, TAZ 1.0%, DI water 84.0%

Formulation BO MEA 4.5%, TMAH 2.5%, ascorbic acid 1.75%, TAZ 5.0%, DI water 86.25%

Formulation BP MEA 9%, TMAH 2.5%, ascorbic acid 3.5%, TAZ 5.0%, DI water 80.0%

Formulation BQ MEA 9%, TMAH 5%, ascorbic acid 3.5%, TAZ 2.0%, DI water 81.5%, pH 11.6

Formulation BR MEA 9%, TMAH 5%, ascorbic acid 2%, gallic acid 3.5%, TAZ 2%, DDBSA 0.11%, DI water 78.39%

Formulation BS MEA 9%, TMAH 5%, ascorbic acid 2%, gallic acid 3.5%, TAZ 2%, NATROSOL® 250 0.1%, DI water 78.4%

Formulation BT MEA 9%, TMAH 5%, ascorbic acid 3.5%, TAZ 2%, NATROSOL® 250 0.1%, DI water 80.4%

Formulation BU MEA 9%, TMAH 5%, ascorbic acid 3.5%, TAZ 2%, KLUCEL® EF 0.1%, DI water 80.4%

Formulation BV MEA 8.82%, TMAH 4.9%, ascorbic acid 3.43%, TAZ 1.96%, NATROSOL® 250 1.00%, DI water 79.89%

Formulation BW MEA 8.82%, TMAH 4.9%, ascorbic acid 3.43%, TAZ 1.96%, NATROSOL® 250 0.50%, DI water 80.39%

Formulation BX MEA 8.82%, TMAH 4.9%, ascorbic acid 3.43%, TAZ 1.96%, KLUCEL® EF 1.00%, DI water 79.89%

Formulation BY MEA 8.82%, TMAH 4.9%, ascorbic acid 3.43%, TAZ 1.96%, KLUCEL® EF 0.50%, DI water 80.39%

Formulation BZ MEA 10.29%, TMAH 5.71 %, ascorbic acid 4.00%, TAZ 2.29%, KLUCEL® EF 1.14%, DI water 76.57%

Formulation CB MEA 8.82%, TMAH 4.9%, ascorbic acid 3.43%, TAZ 1.96%, dodecylbenzenesulfonic acid 0.11 %, DI water 80.78%, pH 12.0

Formulation CE 9 wt. % Monoethanolamine, 5 wt. % Tetramethylammonium hydroxide, 3.5 wt. % Gallic Acid, 2% 1,2,4-Triazole, 80.5 wt. % $H_2O$

Formulation CG 11 wt. % 1-Amino-2-propanol, 5 wt. % Tetramethylammonium hydroxide, 3.5 wt. % Gallic Acid, 2 wt. % Ascorbic Acid, 2% 1,2,4-Triazole, 76.5 wt. % $H_2O$

Formulation CI 7.2 wt. % Monoethanolamine, 4 wt. % Tetramethylammonium hydroxide, 2.8 wt. % Gallic Acid, 1.6 wt. % Ascorbic Acid, 2% 1,2,4-Triazole, 82.4 wt. % $H_2O$

It was discovered by the present inventors that the particle removal efficiency and organic defect removal abilities of alkaline aqueous compositions containing passivating agent was significantly greater than corresponding compositions devoid of passivating agent. For example, it is proposed herein that the presence of passivating agent in the post-CMP cleaning composition assists in the removal of BTA, which is typically a component of CMP slurries and tends to form a thick, non-uniform film on exposed copper surfaces during the preceding CMP process.

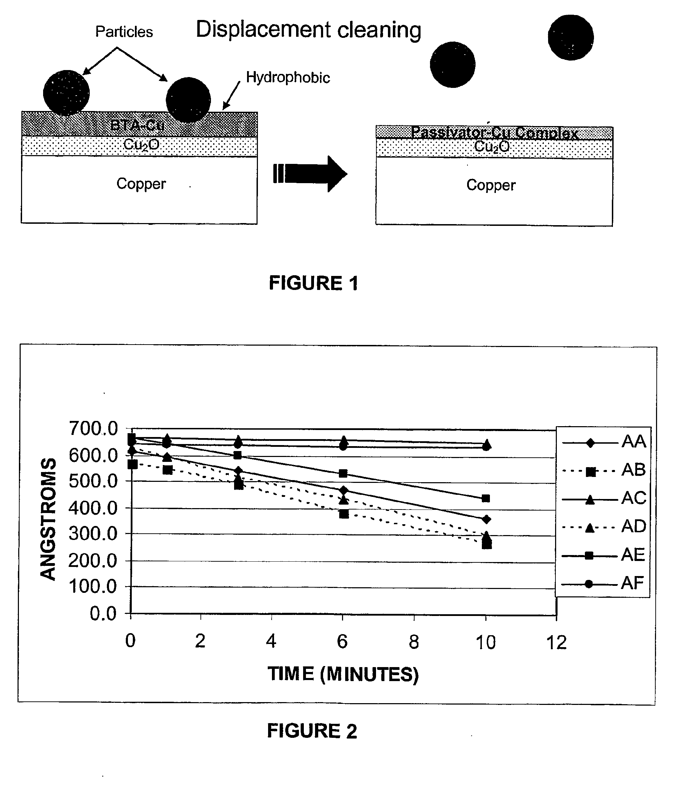

For example, as discussed in the background of the invention, BTA is a component of many CMP slurries and following completion of the CMP process, a non-uniform film of BTA remains on the exposed copper structures. Following CMP with a BTA-containing slurry, the exposed copper surface of the microelectronic device is contaminated with a BTA-$Cu^+$ film as well as particles from the slurry (see left side of Figure 1). Following the introduction of a post-CMP cleaning composition including passivating agent, it is postulated that the BTA-$Cu^+$ layer is undercut and lifted-off, without etching the substrate, leaving behind a passivating agent-$Cu^+$ layer (see right side of Figure 1). The resulting surface is hydrophilic and wets very easily.

Importantly, the aqueous post-CMP cleaning composition of the present invention has a significantly lower surface tension relative to deionized water. This enhances the ability of the aqueous composition of the invention to clean the post-CMP residue and contaminants from the device surface.

In another embodiment, the aqueous post-CMP residue removal composition comprises at least one amine, at least one passivating agent, post-CMP residue, optionally at least one quaternary base, optionally at least one reducing agent, optionally at least one complexing agent, and the balance water. Importantly, the post-CMP residue may be dissolved and/or suspended in the removal composition of the invention.

In yet another embodiment, the aqueous post-CMP removal composition comprises at least one amine, ascorbic acid, at least one passivating agent, optionally at least one quaternary base, optionally at least one additional reducing agent, and water, wherein said alkaline aqueous cleaning composition is suitable for cleaning residue and contaminants from a microelectronic device having said residue and contaminants thereon. Preferably, the clean aqueous post-CMP removal composition is devoid of a fluoride source, an oxidizing agent, and/or abrasive material.

In one embodiment of the invention, a concentrated aqueous post-CMP cleaning composition is provided that can be diluted for use as a cleaning solution. A concentrated composition, or "concentrate," advantageously permits a user, e.g. CMP process engineer, to dilute the concentrate to the desired strength and alkalinity at the point of use. Moreover, the concentrate of the product has a longer shelf life and is easier to ship and store. Dilution of the concentrated cleaning composition may be in a range from about 1:1 to about 200:1, wherein the cleaning composition is diluted at or just before the tool with solvent, e.g., deionized water. Preferably, the concentrated cleaning composition is diluted in a range from about 5:1 to about 50:1.

An important feature of the aqueous post-CMP cleaning composition of the invention is that the non-aqueous constituents (the constituents other than water) are present in the composition in small quantities, often less than about 30 % by weight. This is an economic advantage since an effective cleaning composition can be fornmlated more economically, which is of importance since post-CMP cleaning compositions are used in large quantities. Furthermore, because the cleaning composition is water-based, the cleaning compositions of the invention are more easily disposed of.

The aqueous post-CMP cleaning compositions of the invention are easily formulated by simple addition of the respective ingredients and mixing to homogeneous condition. Furthermore, the aqueous post-CMP cleaning compositions may be readily formulated as single-package formulations or multi-part formulations that are mixed at or before the point of use, e.g., the individual parts of the multi-part formulation may be mixed at the tool or in a storage tank upstream of the tool. The concentrations of the respective ingredients may be widely varied in specific multiples of the aqueous post-CMP cleaning composition, i.e., more dilute or more concentrated, in the broad practice of the invention, and it will be appreciated that the aqueous post-CMP cleaning compositions of the invention can variously and alternatively comprise, consist or consist essentially of any combination of ingredients consistent with the disclosure herein.

Accordingly, another aspect of the invention relates to a kit including, in one or more containers, two or more components adapted to form the compositions of the invention. Preferably, the kit includes, in one or more containers, at least one amine, at least one passivating agent, optionally at least one quaternary base, optionally at least one surfactant, optionally at least one reducing agent, for combining with water at the fab or the point of use. It will be appreciated by one skilled in the art that other combinations are contemplated herein.

In addition to an aqueous solution, it is also contemplated herein that the aqueous post-chip cleaning compositions may be formulated as foams, fogs, subcritical or supercritical fluids (i.e., wherein the solvent is $CO_2$, etc., instead of water).

In yet another embodiment, the aqueous post-CMP cleaning composition of the invention may be utilized in other aspects of the microelectronic device manufacturing process. For example, the aqueous post-CMP cleaning compositions may be used for a post-cobalt clean to remove cobalt-containing particulates from dielectric regions without removing the desired cobalt plating and without damaging the dielectric material. In addition, the aqueous post-CMP cleaning composition of the present invention may be used to remove post-etch and post-ash residue as well as used during a buff process of a CMP polishing tool.

In post-CMP residue and contaminant cleaning application, the aqueous post-CMP cleaning composition may be used with a large variety of conventional cleaning tools, including Verteq single wafer megasonic Goldfinger, OnTrak systems DDS (double-sided scrubbers), Laurell spin-spray tools, SEZ single wafer spray rinse, Applied Materials Mirra-Mesa™ /Reflexion ™/Reflexion LK™, and Megasonic batch wet bench systems.

As applied to microelectronic- manufacturing operations, the aqueous post-CMP cleaning compositions of the present invention are usefully employed to clean post-CMP residue and contaminants from the surface of the microelectronic device, while simultaneously passivating the metallic interconnect materials. Importantly, the cleaning compositions of the invention do not damage low-k dielectric materials on the device surface and preferably remove at least 85 % of the residue present on the device prior to residue removal, more preferably at least 90 %, even more preferably at least 95 %, and most preferred at least 99 %.

In use of the compositions of the invention for cleaning post-CMP residue and contaminants from microelectronic devices having same thereon, the aqueous post-CMP cleaning composition typically is contacted with the device for a time of from about 5 sec to about 10 minutes, preferably about 15 sec to 5 min, at temperature in a range of from about 20°C to about 50°C. Such contacting times and temperatures are illustrative, and any other suitable time and temperature conditions may be employed that are efficacious to at least partially clean the post-CMP residue/contaminants from the device, within the broad practice of the invention. "At least partially clean" and "substantial removal" both correspond to at removal of at least 85 % of the residue present on the device prior to residue removal, more preferably at least 90 %, even more preferably at least 95 %, and most preferred at least 99 %.

In another embodiment, the aqueous post-CMP cleaning composition is introduced to the Step II platen before or during the buffing process, i.e., before or during the reduced platen downforce, whereby the aqueous post-CMP cleaning composition displaces the Step II CMP slurry and assists in the removal of the Step II CMP slurry from the surface of the microelectronic device at the back-end of the Step II CMP process.

Following the achievement of the desired cleaning action, the aqueous post-CMP cleaning composition may be readily removed from the device to which it has previously been applied, as may be desired and efficacious in a given end use application of the compositions of the present invention. Preferably, the rinse solution includes deionized water.

Yet another aspect of the invention relates to the improved microelectronic devices made according to the methods of the invention and to products containing such microelectronic devices.

A still further aspect of the invention relates to methods of manufacturing an article comprising a microelectronic device, said method comprising contacting the microelectronic device with an aqueous post-CMP cleaning composition for sufficient time to clean post-CMP residue and contaminants from the microelectronic device having said residue and contaminants thereon, and incorporating said microelectronic device into said article, wherein the aqueous post-CMP cleaning composition includes components selected from the group consisting of (a) at least one amine, at least one passivating agent, and water, (b) at least one amine, at least one passivating agent, at least one reducing agent and the balance water, (c) at least one amine, at least one passivating agent, at least one surfactant, optionally at least one reducing agent, and the balance water, (d) at least one amine, at least one passivating agent, at least one quaternary base, optionally at least one reducing agent, and the balance water, and (e) at least one amine, at least one passivating agent, at least one quaternary base, at least one reducing agent, optionally at least one surfactant, and the balance water.

In another aspect, the present invention relates to an aqueous post-CMP cleaning composition used as a transfer solution to protect the copper of the electronic device wafer. For example, the post-CMP cleaning compositions disclosed herein may be sprayed onto the wafer during the transfer of said wafer to the polishing platen and/or the post-CMP residue removal process, i.e., brush-scrubbing, megasonics, etc. Preferably, the aqueous post-CMP cleaning composition is diluted with water in a range from about 20:1 to about 1000:1 1 prior to spraying onto the wafer.

The features and advantages of the invention are more fully illustrated by the following nonlimiting examples, wherein all parts and percentages are by weight, unless otherwise expressly stated.

## Example 4

The contact angle for DI water on treated and untreated copper surfaces was determined. The copper surface was an electrochemically deposited copper material having a DI water contact angle of $72.5 \pm 2.2$ without treatment. The ECD copper was immersed in a variety of compositions, as enumerated hereinbelow in Table 1, for one (1) minute, rinsed with DI water, dried with nitrogen and the contact angle of the DI water determined. The results are tabulated in Table 1.

**Table 1: DI water contact angle on treated and untreated copper surfaces.**

|  | Contact Angle(°) |
| --- | --- |
| Control | $72.5 \pm 2.2$ |
| 0.1 wt. % BTA | $49.8 \pm 1.5$ |
| 0.01 wt. % CBTA | $33.4 \pm 3.2$ |
| 0.2 wt. % TAZ | $12.5 \pm 1.7$ |
| 0.1 wt. % ATA | $16.4 \pm 1.3$ |
| formulation BQ (diluted 10:1) | $12.5 \pm 1.0$ |

In addition, ECD copper was treated with a passivator-free cleaning composition, followed by 0.1 wt. % BTA, rinsed and dried. This treated copper surface had a contact angle of about 50-60°. When this treated ECD copper surface was further immersed in formulation BQ (diluted 10:1), rinsed and dried, the contact angle dropped $12.5 \pm 1.6$.

It can be seen that the copper treated with a composition comprising 0.1 wt. % BTA had a contact angle of approximately 50°-60°, indicating that the treated surface was relatively hydrophobic (i.e., non-wetting). In contrast, the copper treated with TAZ has a contact angle of approximately 10°-15°, indicating that the treated surface was hydrophilic. Interestingly, after said BTA-treated copper surface was immersed in formulation BQ comprising TAZ , the contact angle for DI water decreased to about 10°-15° (i.e., the contact angle for the TAZ-treated surface), suggesting that the TAZ either (i) adsorbed to the BTA-Cu$^+$ surface or (ii) displaced the BTA from the Cu surface leaving behind TAZ-Cu$^+$.

## Example 5

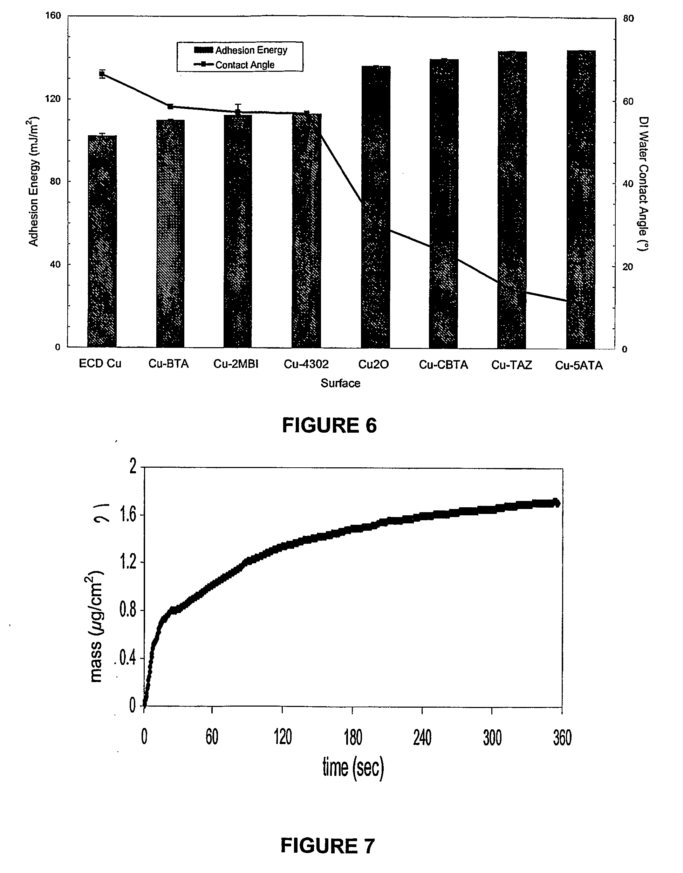

The contact angle and corresponding surface energy for DI water on treated and untreated copper surfaces was determined and illustrated in Figure 6. The surfaces examined are summarized below.

ECD Cu     Electrochemically deposited copper (control)
Cu-BTA     ECD Cu immersed in a 0.1 % BTA solution at natural pH
Cu-2MBI     ECD Cu immersed in a 0.01 % MBI solution at natural pH
Cu-4302     ECD Cu immersed in 0.1% of a proprietary modified triazole composition
Cu$_2$O     ECD Cu treated with a composition to convert surface CuO to Cu$_2$O
Cu-CBTA     ECD Cu immersed in a 0.01 % CBTA solution at natural pH
Cu-TAZ     ECD Cu immersed in a 0.2% TAZ solution at natural pH
Cu-5ATA     ECD Cu immersed in a ATA solution at natural pH

In many of the tested solutions, the amount of copper passivator dissolved therein was dictated by the solubility of said compound at natural pH, which tended to be in the 4-6 pH range.

The results illustrate that a suitable universal copper passivator may be predicted simply by measuring contact angles rather than performing actual cleaning and passivation experiments. For example, the results illustrate which copper passivators will provide the best "wetting" of the surface thereby increasing the likelihood that the aqueous cleaning solution is able to penetrate into high aspect ratio structures during post-CMP cleans and decreasing the ability to form "water spots" on the exposed copper surfaces.

## Example 6

The adsorption of TAZ onto a copper surface was determined in both acidic and basic media. An electrode on a quartz crystal microbalance (QCM) was plated with copper and inunersed in DI water at 23°C at a pH of approximately 5 for 360 seconds. The results of the acidic control experiment are illustrated in Figure 7, showing an observed mass increase of approximately 1.66 $\mu$g cm$^{-2}$ at 300 sec, due to oxidation and hydration processes.

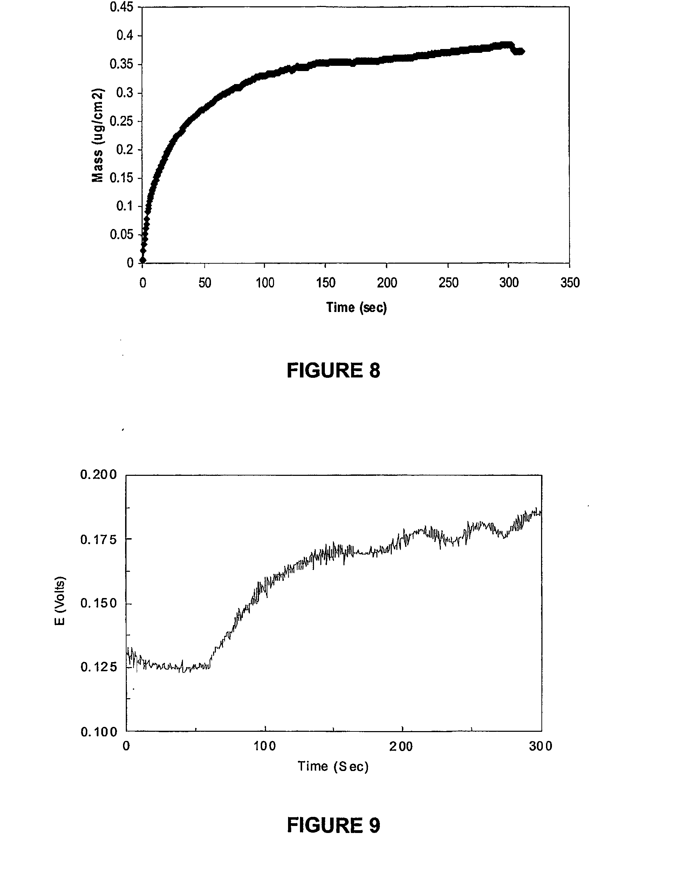

The copper-plated QCM electrode was then immersed in a solution containing 0.058 wt.% TAZ at pH 5.8 (the natural pH of the solution). The results of the experiment in acidic media are illustrated in Figure 8, showing an observed mass increase of approximately 0.38 $\mu$g cm$^{-2}$ at 300 sec, which corresponds to a TAZ film thickness of approximately 26Å. Figure 9 illustrates the corresponding open circuit potential (OCP), relative to an Ag/AgCl reference electrode, for this experiment in the acidic media. It can be seen that the potential for the adsorbed TAZ, having a QCM determined thickness of approximately 0.38 $\mu$g cm$^{-2}$ at 300 sec, corresponds to approximately 0.18V.

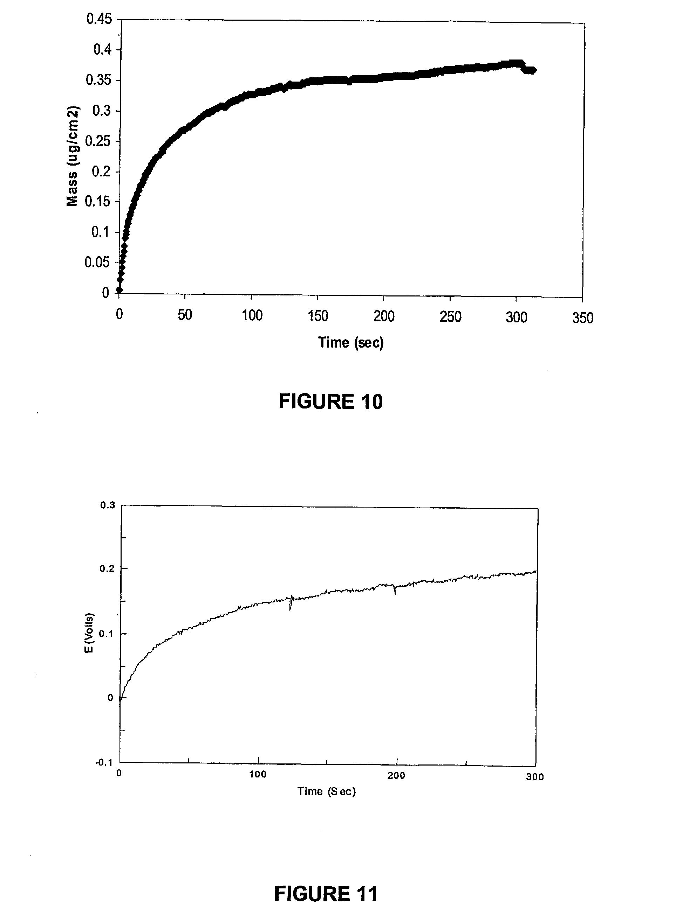

The experiment was repeated by immersing the copper-plated QCM electrode in a basic DI water solution which was adjusted to pH 11.5 using TMAH. The results of the basic control experiment are illustrated in Figure 10, showing an observed mass increase of approximately 0.44 $\mu$g cm$^{-2}$ at 300 sec.

The copper-plated QCM electrode was then immersed in a solution containing 0.058 wt.% TAZ adjusted to pH 11.5 using TMAH. The QCM results of the experiment in basic media were inconclusive however, Figure 11 illustrates the corresponding OCP for this experiment in the basic media. It can be seen that the potential for the adsorbed TAZ in the basic media corresponds to approximately 0.195 V. The similarities between the OCP results in the acidic TAZ solution and the basic TAZ solution suggest that TAZ will consistently adsorb at exposed copper surfaces regardless of the pH of the solution. This is relevant because CMP requires a variety of different slurries having a variety of pH values and the residual CMP slurry often contaminates post-CMP cleaning compositions thus altering the pH of the cleaning composition. Preferably, the passivator adsorbs to exposed copper equivalently, regardless of the pH, thereby broadening the applicability of the cleaning composition.

## Example 7

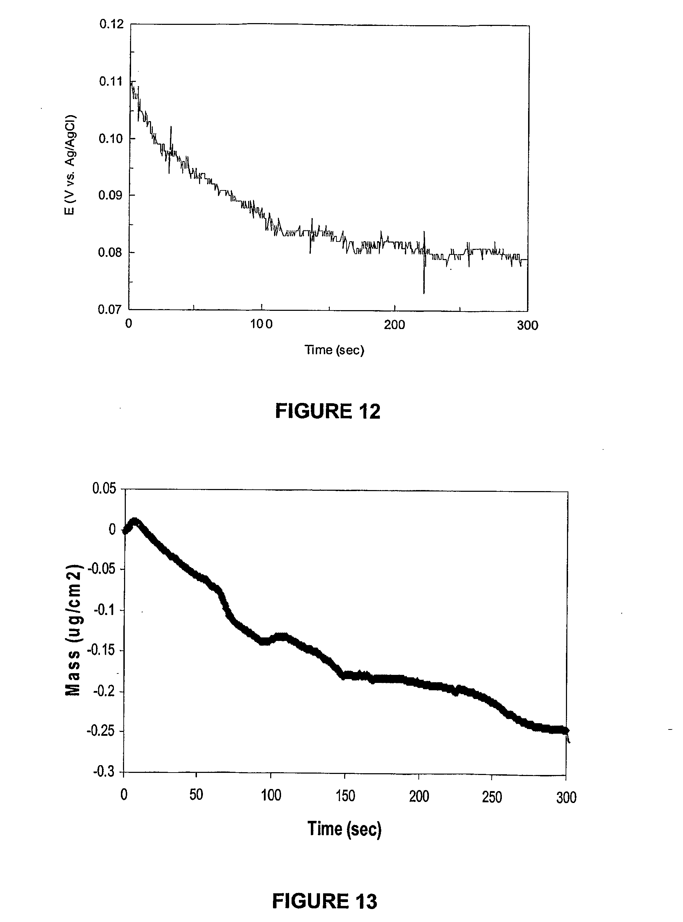

The adsorption of TAZ onto a BTA-treated copper surface was determined in a basic medium. An electrode on a quartz crystal microbalance (QCM) was plated with copper and immersed in a 0.2 wt. % BTA solution having a neutral pH at 23°C for 300 seconds. Thereafter, the BTA-treated copper was immersed in a 0.1 wt. % TAZ solution having a pH of 11.5 for 300 sec. The results of the OCP and QCM experiments are illustrated in Figures 12 and 13, respectively. It can be seen that the mass of the electrode decreased, evidencing displacement of the heavier BTA molecules (MW 119.1 g mole$^{-1}$) by the lighter TAZ molecules (69.07 g mole$^{-1}$). The results of this experiment suggest that at least a portion of the BTA is displaced by the TAZ molecules.

## Example 8

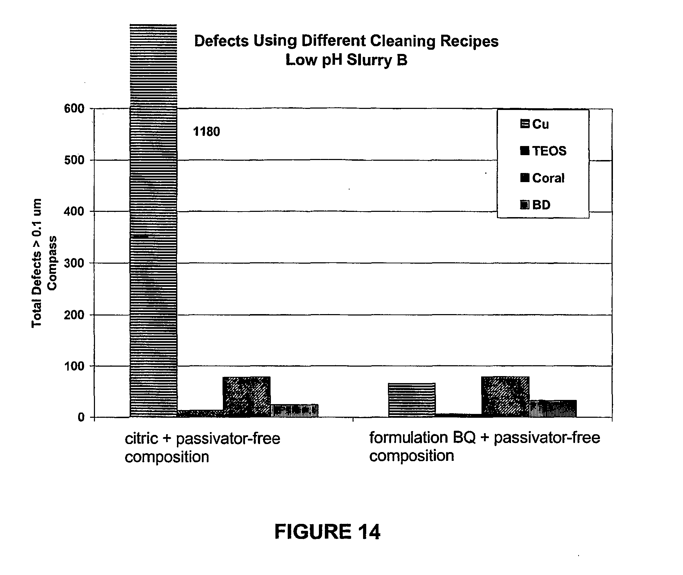

Figure 14 illustrates the total number of defects remaining on copper, TEOS, Coral and Black Diamond (BD) surfaces following two different cleaning methodologies. A Compass defect analysis tool was used to count the number of defects having a size greater than 0.1 $\mu$m on each surface. The first cleaning methodology is a conventional one used in the art whereby subsequent to CMP, the wafer is immersed in a citric acid solution and brush cleaned with a cleaning composition devoid of passivator, in this case a composition including MEA, TMAH, ascorbic acid and DI water. The second cleaning methodology involves the immersion of the wafer subsequent to CMP, in Formulation BQ, followed by brush cleaning with the aforementioned passivator-free cleaning composition.

Referring to Figure 14, it can be seen the copper cleaned according to the first methodology had a substantial number of defects, mostly organic defects possibly due to the presence of adsorbed BTA from the preceding CMP process. When the copper was cleaned according to the second methodology, wherein the surface is immersed in a composition comprising TAZ (Formulation BQ), the number of defects decreased dramatically. These results further evidence that the BTA is displaced by the TAZ during the post-CMP clean. Accordingly, another advantage of the BTA displacement by TAZ is the reduced number of surface defects and thus, the increased reliability of the overall microelectronic device.

## Example 9

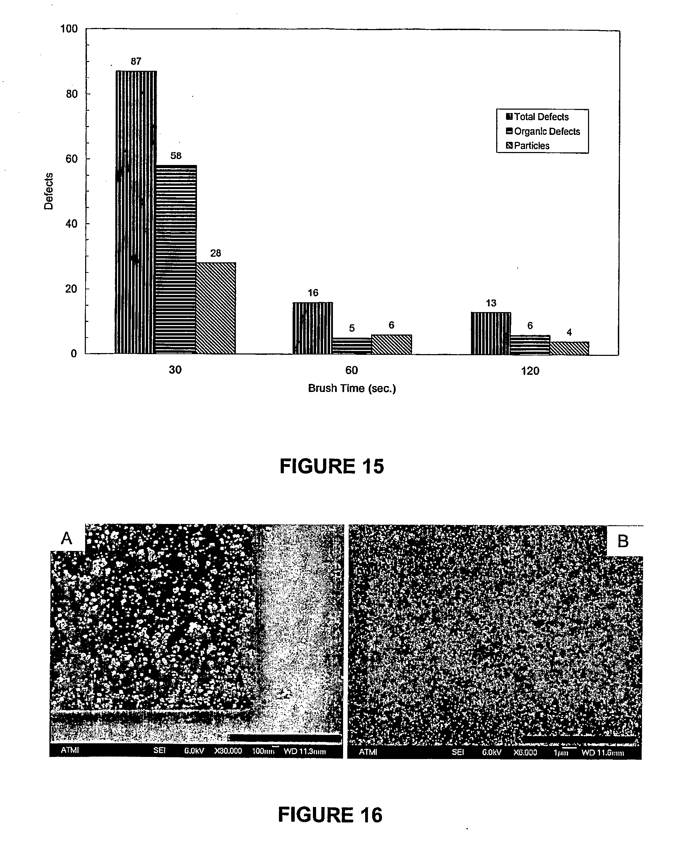

Figure 15 illustrates the number of total defects, organic defects and particle defects as a function of time for a blanketed copper wafer following a rinse-buff during the CMP buff step with a 10:1 dilution of formulation BF (with DI water) followed by post-CMP cleaning in a brush box using a 30:1 dilution of a concentrated composition including 4.7% TMAH, 20.6% TEA, 3.3% gallic acid, 11.2% ascorbic acid and the balance water It can be seen that the number of defects, organic, particle and total, decreased as brush time increased. These results indicate that a brush clean was necessary, preferably for at least 60 seconds, to remove a substantial amount of the defects.

## Example 10

Figure 16A is a scanning electron micrograph of a Sematech 854 control at the edge of a bond pad at a magnification of 30,000x, wherein the wafer has CMP residue and slurry contaminants thereon. Figure 16B is an SEM of the Sematech 854 control wafer at one randomly selected bond pad at a magnification of 6,000x.

The Sematech 854 control wafers were cleaned using a Laurell spin-spray tool with a 60:1 dilution (with DI water) of the cleaning formulations of the present invention for 60 sec at 22°C.

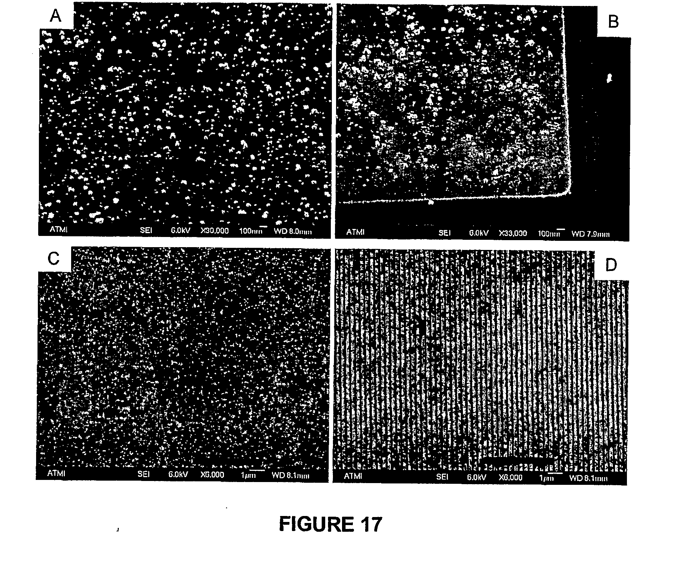

For Figures 17-26, which correspond to a clean with formulations BH-BM, BF and BN-BP, respectively, figure A is an SEM of the wafer following spin/spray treatment at the center of a bond pad at a magnification of 30,000x, figure B is an SEM of the wafer following spin/spray treatment at the edge of a bond pad at a magnification of 30,000x, figure C is an SEM of the wafer following spin/spray treatment at a randomly selected bond pad at a magnification of 6,000x, and figure D is an SEM of the wafer following spin/spray treatment at an area of the $0.18\mu$m line pattern at a magnification of 6,000x.

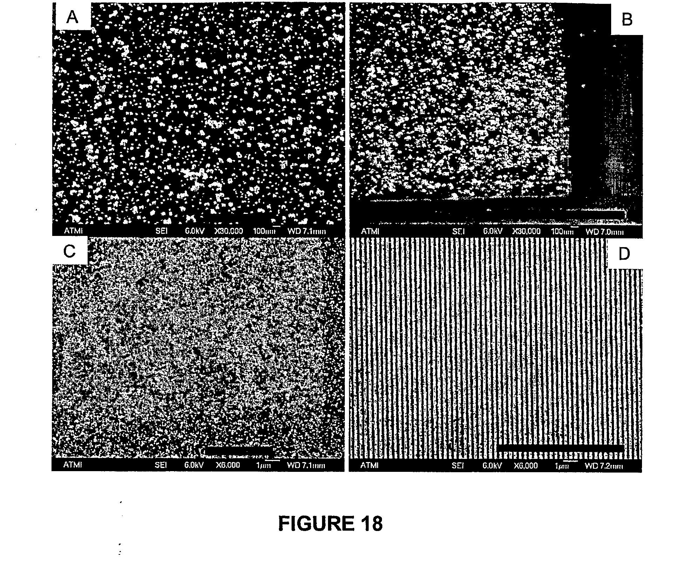

Figures 17 and 18, corresponding to wafers cleaned with formulations comprising BTA (formulations BH and BI, respectively), evidencing that post-CMP cleaning compositions comprising BTA are not suitable for the removal of residue and contaninants.

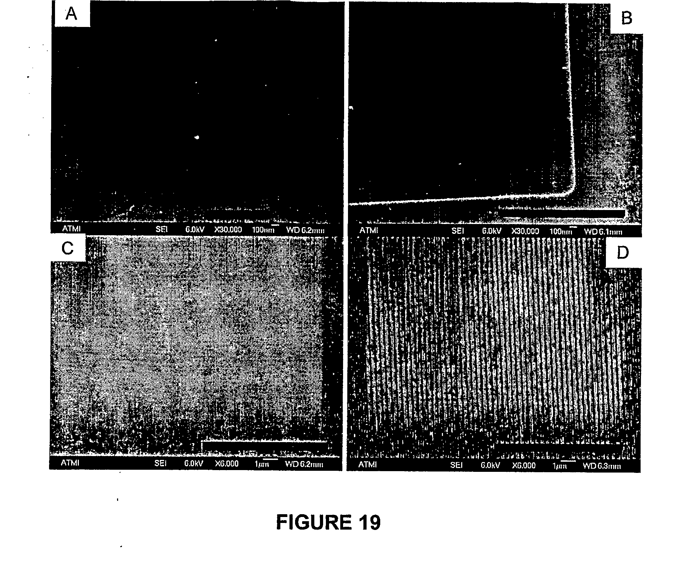

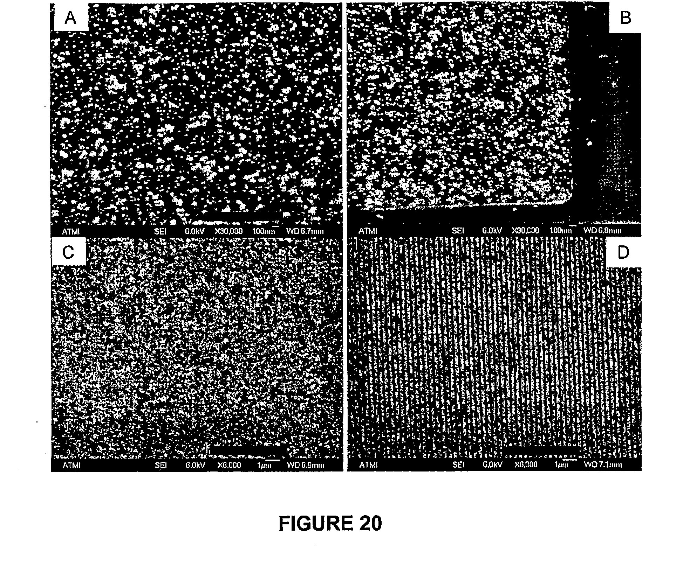

Figure 19, corresponding to a wafer cleaned with the formulation comprising a low concentration of CBTA (formulation BJ), illustrates the substantial removal of post-CMP residue and contaminants. However, Figure 20, corresponding to a wafer cleaned with the formulation comprising a high concentration of CBTA (formulation BK), illustrates the failure of the more concentrated formulation at removing the residue and contaminants. Although not wishing to be bound by theory, this distinct difference is thought to be due to a balance between the passivator and the other components in the formulation. High concentrations of passivator may inhibit the cleaning capabilities of the formulation.

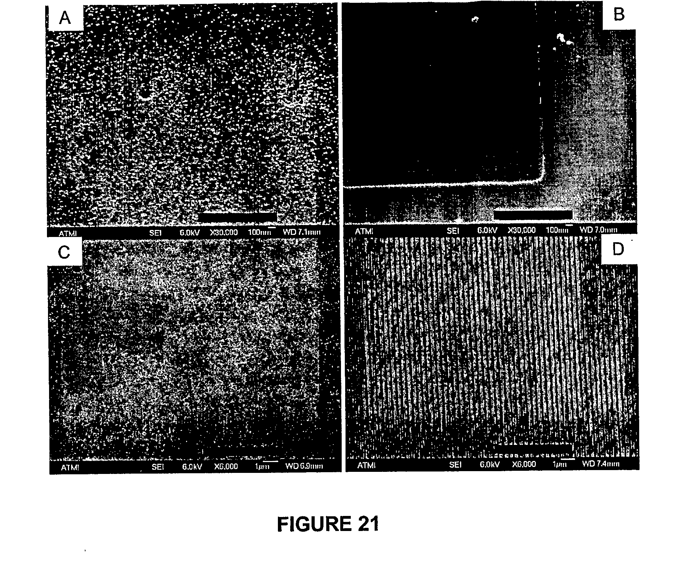

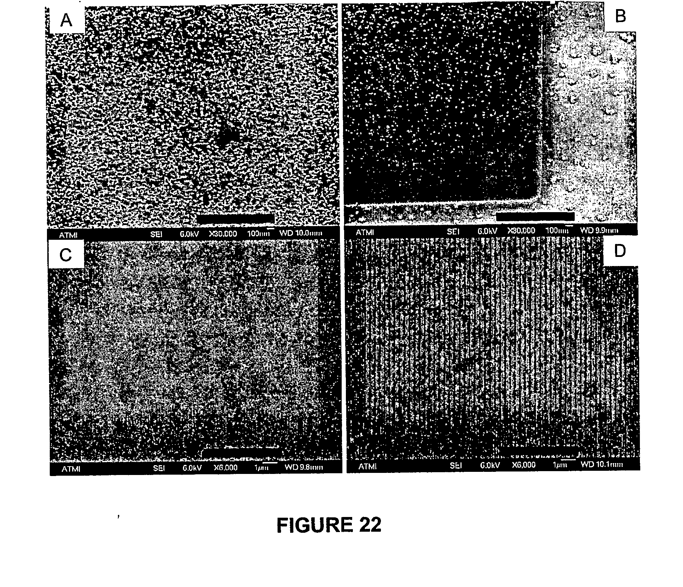

Figures 21 and 22, corresponding to wafers cleaned with formulations comprising ATA (formulations BL and BM, respectively), illustrate a cleaning behavior similar to CBTA (i.e., Figures 19 and 20), whereby the less concentrated ATA composition substantially removed the residue and contaminants but the more concentrated ATA composition did not. It is further noted that a film appeared to adsorb to the surface of the wafer for both compositions comprising ATA, possibly due to too high of a passivator level causing uneven particulate deposition of the passivators onto the copper.

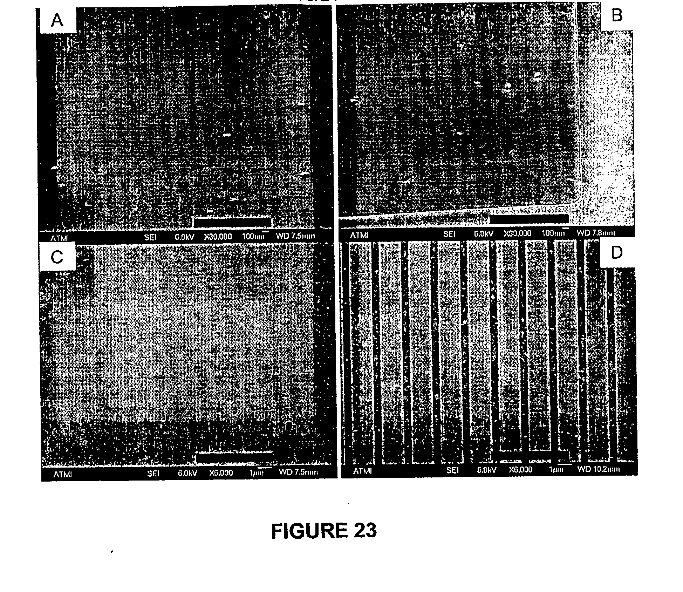

Figure 23, corresponding to a wafer cleaned with a formulation comprising TAZ (formulation BF), illustrates the substantial removal of post-CMP residue and contaminants.

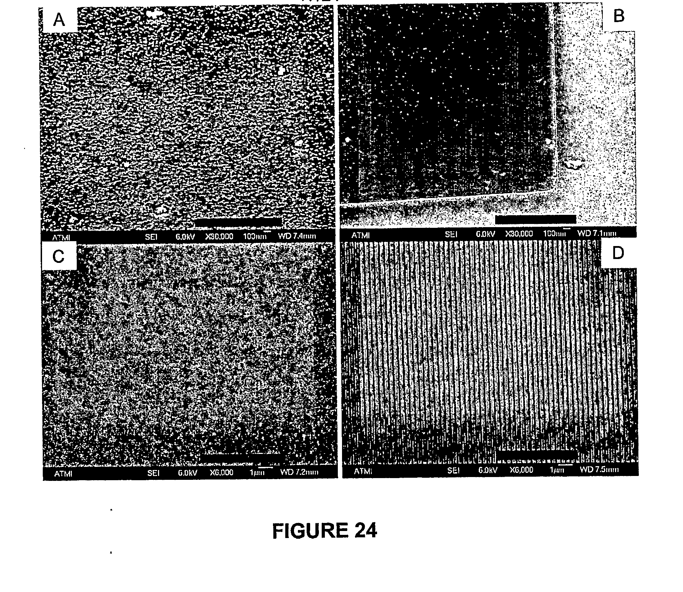

Figure 24 corresponding to a wafer cleaned with a formulation comprising TAZ (formulation BN), illustrates the substantial removal of post-CMP residue, however, a film adsorbed to the surface of the wafer during the clean.

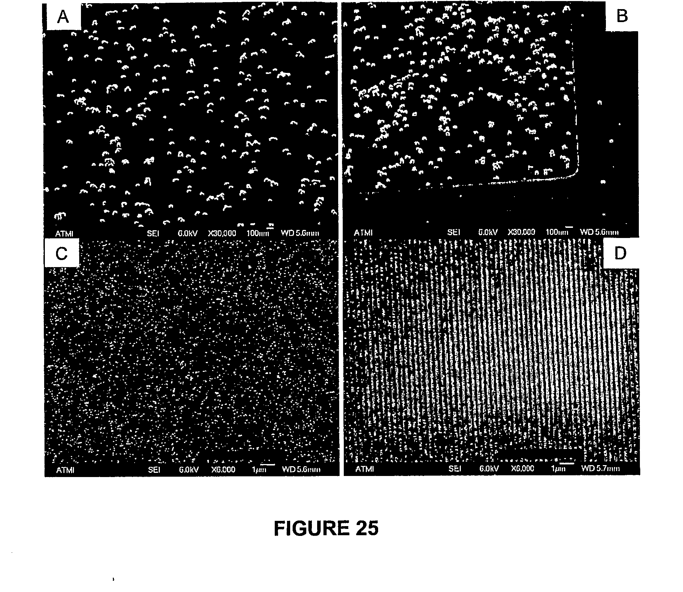

Figure 25 corresponding to a wafer cleaned with a formulation comprising TAZ (formulation BO), illustrates the removal of the smaller post-CMP residue matter however, the formulation was unable to remove the larger particulate matter from the surface of the wafer. It is noted that the BO formulation did substantially remove all post-CMP residue matter and contaminants from proprietary wafers (not shown herein). This suggests that the usefulness of all formulations is dependent on the nature of the materials on the wafer as well as the nature of the preceding CMP polish.

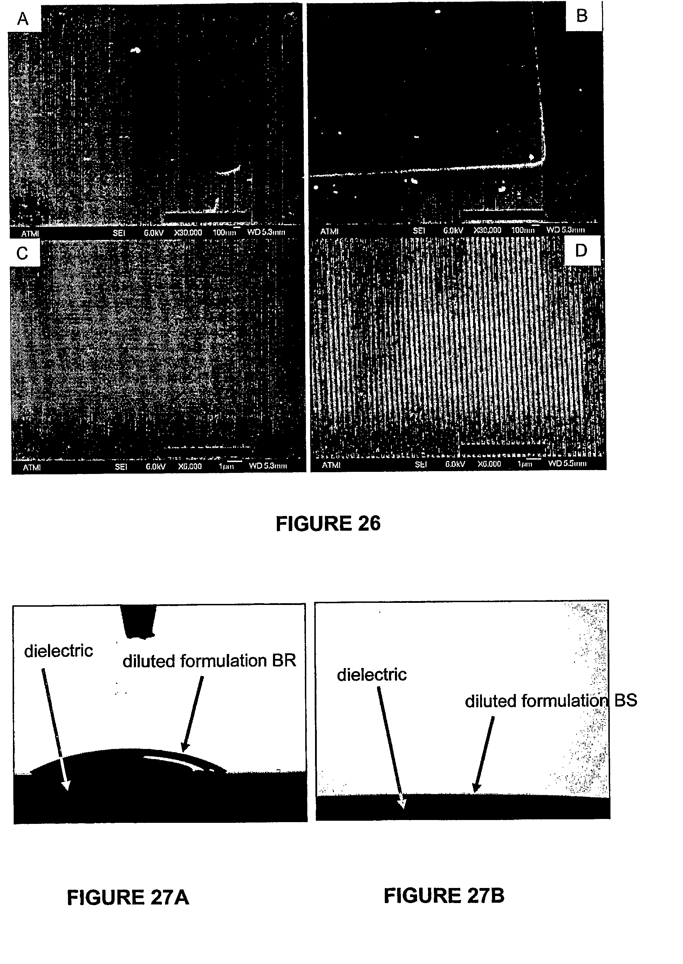

Figure 26, corresponding to a wafer cleaned with a formulation comprising TAZ (formulation BP), illustrates the substantial removal of post-CMP residue and contaminants.

## Example 11

The contact angle of diluted formulations BR and BS on dielectric material was determined. Formulation BR was diluted to form a 2.561 BR: 97.839 DI water solution. Formulation BS was diluted to form a 2.56 BS: 97.84 DI water solution. Optical images of the observed contact angles are shown in Figures 27A and 27B.

## Example 12

The efficacy of formulations BQ, CC-CG and CJ-CM for cleaning post-CMP residue and contaminants from a microelectronic device having same thereon was evaluated. The device was a patterned Sematech 854 wafer which had dried Arch10K CMP slurry and other post-CMP residues on the surface. The wafer in each instance was cleaned on a spin/spray tool for 1 minute at 22°C at 100 rpm with the specific cleaning composition diluted x:1 (1 part cleaning composition to x parts deionized water), followed by a 30 second deionized water rinse and spin dry. Pre- and post-cleaning analysis was carried out using a Nanoscope IIIa atomic force microscope (AFM).

The cleaning efficacy was rated by the reduction of objects on the substrate. The particles on the sample substrates were "registered" as a range of pixels from 231-235 intensity, which on a typical AFM image correspond to white species on an otherwise dark background. A Sigma Scan Pro histogram was applied to filter these pixels and count the number of particles. The cleaning efficacy was calculated using equation (1).

$$\text{cleaning efficacy} = \frac{\text{\# pre - clean particles} - \text{\# of post - clean particles}}{\text{\# of pre - clean particles}} \times 100 \qquad (1)$$

Table 2 includes the post-CMP cleaning efficacy results for compositions BQ, CC-CG and CJ-CM described hereinabove at the indicated dilutions.

Table 2: Post-CMP residue and contaminant cleaning efficacy of the compositions of the present invention.

| Formulation | Dilution | Cleaning Efficacy/% |
|---|---|---|
| BQ | 30:1 | 99.0 |
| CC | 30:1 | 70.0 |
| CD | 30:1 | 97.4 |
| CE | 30:1 | 99.7 |
| CF | 30:1 | 98.0 |
| CG | 30:1 | 99.0 |
| CJ | 30:1 | 0 |
| CK | 30:1 | 0 |
| CL | 30:1 | 0 |
| CM | 30:1 | 0 |

It can be seen that formulation BQ shows 19% improvement in cleaning over Formulation CC, which does not contain the copper passivating agent TAZ. Formulations CE and CG show 2% and 1% improvement, respectively, in cleaning over formulations CD and CF, which do not contain the copper passivating agent TAZ. Formulations containing BTA as a passivating agent, specifically CJ, CK, CL, and CM, have extremely poor cleaning due to the addition of particles during cleaning.

## Example 13

The copper roughening of blanket polished copper wafers in the presence of formulations BQ and CC-CE was evaluated. The wafer in each instance was cleaned on a spin/spray tool for 1 minute at 22°C at 100 rpm with the specific cleaning composition diluted x:1 (1 part cleaning composition to x parts deionized water), followed by a 30 second deionized water rinse and spin dry. Pre- and post-cleaning analysis was carried out using a Nanoscope IIIa AFM. The roughening was rated by the Root Mean Square roughness as calculated by the AFM software. The results are tabulated in Table 3 hereinbelow.

Table 3: Copper roughness using the compositions of the present invention.

| Formulation | Dilution | RMS roughness% |
|---|---|---|
| BQ | 30:1 | 1.01 |
| CC | 30:1 | 1.42 |
| CD | 30:1 | 1.14 |
| CE | 30:1 | 1.17 |

The data shows that the addition of a passivating agent to the cleaning compositions of the invention, i.e., formulations CC and CE, does not adversely effect the copper roughening due to the formulations.

## Example 14

The efficacy of formulations CC, CD, CF, CH and CI for cleaning post-CMP residue and contaminants from a microelectronic device having same thereon was evaluated. The device was a patterned Sematech 854 wafer which had dried Arch10K CMP slurry on the surface. The wafers were further contaminated with 10ppm BTA for 2 hours by static immersion. The wafer in each instance was cleaned on a spin/spray tool for 1 minute at 22°C at 100 rpm with the specific cleaning composition diluted x:1 (1 part cleaning composition to x parts deionized water), followed by a 30 second deionized water rinse and spin dry. Pre- and post-cleaning analysis was carried out using a Nanoscope IIIa atomic force microscope (AFM). The cleaning efficacy was rated according to the method of Example 12 and calculated using equation (1) hereinabove. The results are tablulated in Table 4 hereinbelow.

Table 4: Post-CMP residue and contaminant cleaning efficacy of the compositions of the present invention.

| Formulation | Dilution | Cleaning Efficacy/% |
|---|---|---|
| CC | 30:1 | 92.6 |
| CD | 30:1 | 46.1 |
| CF | 30:1 | 86.4 |
| CH | 30:1 | 86.4 |
| CI | 30:1 | 98.6 |

It can be seen that formulation CI, which includes TAZ, shows improved cleaning, of the slurry and BTA contamination compared to formulations without the TAZ passivating agent.

## Example 15

The efficacy of formulations BQ and CC-CG for cleaning BTA residue from a copper surface was evaluated. The copper surface was blanket seed wafer which had been treated with 10ppm of BTA for 2 hours by static immersion. The wafer in each instance was cleaned on a spin/spray tool for 1 minute at 22°C at 100 rpm with the specific formulation diluted x:1 (1 part cleaning composition to x parts deionized water), followed by a 30 second deionized water rinse and spin dry. The wafer was then exposed to $H_2S$ gas for 2 minutes. Discoloration caused by exposure to the gas indicates the level of BTA contamination remaining on the BTA-treated copper surface, whereby the BTA removal from least to most corresponds to orange < red < pink < purple < blue. The results are tabulated in Table 5 hereinbelow.

Table 5: Level of BTA contamination remaining following treatment with the specific formulation and exposure to $H_2S$ gas.

| Contamination | Formulation | Color after exposure to $H_2S$ gas |
|---|---|---|
| None | None | Purple/Blue |
| 10ppm BTA | None | Orange |
| 10ppm BTA | CC | Pink |
| 10ppm BTA | BQ | Blue |

(continued)

| Contamination | Formulation | Color after exposure to $H_2S$ gas |
|---|---|---|
| 10ppm BTA | CD | Pink |
| 10ppm BTA | CE | Blue |
| 10ppm BTA | CF | Red |
| 10ppm BTA | CG | Pink/Purple |

The surfaces cleaned with the formulations of the invention including TAZ, specifically BQ, CE, and CG, were more significantly discolored, i.e., evidenced significant BTA removal, than the formulations devoid of the TAZ passivating agent. XPS results verify that that formulations comprising TAZ left a thin layer of TAZ passivated copper behind. These results support the theory that the formulations of the invention comprising TAZ displace the BTA from the surface of the wafer.

## Example 16

Various embodiments were formulated, wherein all percentages are by weight, based on the total weight of the formulation. Some formulations are preferred and some were formulated for comparison purposes.

Formulation DA     9 wt. % Monoethanolamine, 91 wt.% $H_2O$
Formulation DB     9 wt. % Monoethanolamine, 0.1 wt% 2-Mercaptobenzimidazole, 90.9 wt.% $H_2O$
Fonnulation DC     11 wt. % 1-Amino-2-propanol, 89 wt.% $H_2O$
Formulation DD     11 wt. % 1-Amino-2-propanol, 0.1 wt.%Carboxybenzotriazole, 88.9 wt.% $H_2O$
Formulation DE     11 wt. % NMEA, 89 wt.% $H_2O$
Formulation DF     11 wt. % NMEA, 0.1 wt% 5-Aminotetrazole, 88.9 wt.% $H_2O$
Formulation DG     11 wt. % NMEA, 0.1 wt% 5-Aminotetrazole, 1 wt% (40%) Glyoxal, 87.9 wt.% $H_2O$

## Example 17

Formulations DA-DG were evaluated for copper etch rate. The substrate was a blanketed copper wafer. The wafer in each instance was immersed in the respective composition for 10 minutes at 22°C at 450 rpm, followed by a 30 sec deionized water rinse and nitrogen dry. Pre- and post-cleaning analysis was carried out using a Res Map four point probe to determine thickness of the copper. The etch rate (ER) of copper in the presence of the formulations was calculated using equation (2). The variance of the etch rate is calculated using equation (3).

$$\text{Cu ER} = \frac{A - B}{T} \qquad (2)$$

where A is the thickness of the substrate before immersion in Angstroms, B is the thickness of the substrate after immersion Angstroms, and T is the time in minutes,

$$\text{Cu ER Error} = \frac{\sqrt{SA^2 + SB^2}}{T} \qquad (3)$$

where SA = variance of the thickness of the substrate before treatment in Angstroms, SB is the variance of the thickness of the substrate after immersion in Angstroms, and t is the time in minutes.
The results of the etch rate determination experiments are summarized in Tables 6 and 7 below, wherein the 20:1 solution of DA and DB represents the 20:1 dilution of DA and DB in DI water.

Table 6: Copper thickness and etch rates following immersion in Formulations DA-DG.

| Formulation | DA (20:1) | DB (20:1) | DA | DB | DC | DD | DE | DF | DG |
|---|---|---|---|---|---|---|---|---|---|
| Thickness prior to immersion (Å) | 764.3 | 785 | 769.1 | 737.1 | 790.2 | 797.5 | 779.1 | 750.7 | 779.8 |
| Thickness subsequent to immersion (Å) | 636.7 | 783.4 | 506.7 | 724.3 | 478.3 | 685.9 | 630.6 | 627.9 | 693.3 |
| ER(Åmm$^{-1}$) | 12.8 | 0.2 | 26.2 | 1.3 | 31.2 | 11.2 | 14.9 | 12.3 | 8.7 |

Table 7: Variance of copper thickness and variance of the etch rate.

| Formulation | DA (20:1) | DB (20:1) | DA | DB | DC | DD | DE | DF | DG |
|---|---|---|---|---|---|---|---|---|---|
| Variance prior to immersion (Å) | 2.6 | 1.7 | 1.6 | 4.7 | 1 | 0.9 | 1.5 | 3 | 1.4 |
| Variance subsequent to immersion (Å) | 12.1 | 1.7 | 52.5 | 3.1 | 17.6 | 9.4 | 26.8 | 6.2 | 2.5 |
| ER Variance (Å min$^{-1}$) | 1.2 | 0.2 | 1.3 | 0.6 | 1.8 | 0.9 | 2.7 | 0.7 | 0.3 |

It can be seen that the addition of the passivating agent to formulations DB, DD, and DF contributed to a much lower etch rate and lower variance in the copper etch rate of the sample than formulations DA, DC, and DE (i.e., formulations without the passivating agent). The addition of the reducing agent glyoxal to formulation DG further reduced the etch rate and the variance of the copper etch rate compared to formulations DE and DF (i.e., formulations devoid of reducing agent).

**Example 18**

Samples of Formulations EA-EP, having the respective compositions described below, were prepared.

Formula EA   9 wt. % Monoethanolamine, 5 wt. % Tetramethylammonium hydroxide, 3.5 wt. % Ascorbic Acid, 82.5 wt.% $H_2O$

Formula EB   1 wt. % 1,2,4-Triazole, 99 wt.% $H_2O$

Formula EC   1.75 wt. % Ascorbic Acid, 1 wt. % 1,2,4-Triazole, 97.25 wt.% $H_2O$

Formula ED   2.5 wt. % Tetramethylammonium hydroxide, 1.75 wt. % Ascorbic Acid, 1 wt. % 1,2,4-Triazole, 94.75 wt. % $H_2O$

Formula EE   4.5 wt. % Monoethanolamine, 1 wt. % 1,2,4-triazole, 94.5 wt.% $H_2O$

Formula EF   4.5 wt. % Monoethanolamine, 1.75 wt. % Ascorbic Acid, 1 wt. % 1,2,4-triazole, 92.75 wt.% $H_2O$

Formula EG   2.5 wt. % Tetramethylammonium hydroxide, 1 wt. % 1,2,4-triazole, 96.5 wt.% $H_2O$

Formula EH   9 wt. % Monoethanolamine, 5 wt. % Tetramethylammonium hydroxide, 3.5 wt. % Gallic Acid, 2 wt. % Ascorbic Acid, 2 wt. % 1,2,4-triazole, 78.5 wt.% $H_2O$

Formula EI   9 wt. % Monoethanolamine, 5 wt. % Tetramethylammonium hydroxide, 3.5 wt. % Gallic Acid, 2 wt. % Ascorbic Acid, 1 wt. % Benzotriazole, 79.5 wt.% $H_2O$

Formula EJ  9 wt. % Monoethanolamine, 5 wt. % Tetramethylammonium hydroxide, 3.5 wt. % Gallic Acid, 10.9 wt. % Ascorbic Acid, 71.6 wt.% $H_2O$

Formula EK  9 wt. % Monoethanolamine, 5 wt. % Tetramethylammonium hydroxide, 3.5 wt. % Gallic Acid, 10.9 wt. % Ascorbic Acid, 2 wt. % 1,2,4-Triazole, 69.6 wt.% $H_2O$

Formula EL  5.5 wt. % Monoisopropanolamine, 1.75 wt. % Ascorbic Acid, 1 wt. % 1,2,4-triazole, 91.75 wt.% $H_2O$

Formula EM  7.75 wt. % Aminoethoxyethanol, 1.75 wt. % Ascorbic Acid, 1 wt. % 1,2,4-triazole, 89.5 wt.% $H_2O$

Formula EN  5.5 wt. % Monoisopropanolamine, 1.75 wt. % Ascorbic Acid, 92.75 wt.% $H_2O$

Formula EO  4.5 wt. % Monoethanolamine, 1.75 wt. % Ascorbic Acid, 93.75 wt.% $H_2O$

Formula EP  9.0 wt. % Monoethanolamine, 3.5 wt. % Ascorbic Acid, 2 wt. % 1,2,4-triazole, 85.5 wt.% $H_2O$

### Example 19

The efficacy of formulations BG, EA-EG, EL and EM for cleaning post-CMP residue and contaminants from a microelectronic device containing same thereon was evaluated. The device was a patterned Sematech 854 wafer which had dried CMP slurry and other post-CMP residues on the surface. The wafer in each instance was cleaned on a spin/spray tool for 1 minute at 22°C at 100 rpm with the specific cleaning composition diluted x:1 (1 part cleaning composition to x parts deionized water), followed by a 30 second deionized water rinse and spin dry. Pre- and post-cleaning analysis was carried out using a Nanoscope IIIa atomic force microscope (AFM). The cleaning efficacy was rated by the reduction of objects on the substrate as described hereinabove and was calculated using equation (1).

Table 8 includes the post-CMP cleaning efficacy results for compositions BG, EA-EG, EL and EM described hereinabove at the indicated dilutions.

Table 8: Post-CMP residue and contaminant cleaning efficacy of the compositions of the present invention.

| Formulation | Dilution | Cleaning Efficacy/% |
|---|---|---|
| EA | 10:1 | 79 |
| BG | 5:1 | 100 |
| EB | 5:1 | -4 |
| EC | 5:1 | -2 |
| ED | 5:1 | -3 |
| EE | 5:1 | -42 |
| EF | 5:1 | 99 |
| EG | 5:1 | -2 |
| EL | 5:1 | 99 |
| EM | 5:1 | 90 |

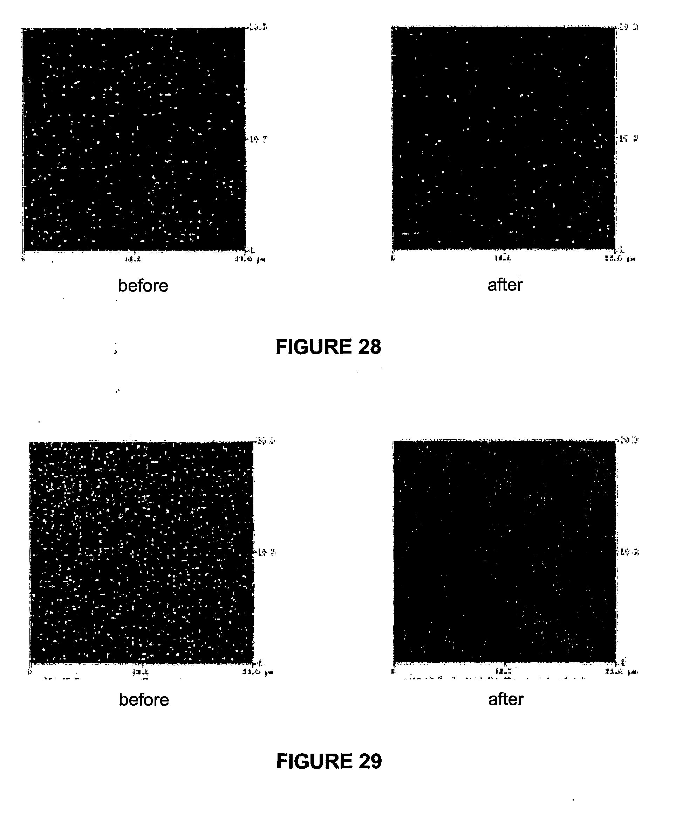

It can be seen that formulation EC (TAZ and ascorbic acid) and formulation EE (TAZ and monoethanolamine) did not clean the post-CMP residue and contaminant from the wafer surface. Unexpectedly and surprisingly, however, when the components of formulations EC and EE were combined to form formulation EF (TAZ, ascorbic acid, monoethanolamine), the cleaning efficacy was nearly 100 %. The surprising effect is further illustrated in Figures 28 and 29, which represent the AFM images of the pre- and post-clean using formulations EC and EF, respectively. It can be clearly seen that formulation EC had no effect on the number of particles (i.e., white spots) cleaned from the wafer surface, while formulation EF efficaciously cleaned the wafer surface. Similarly, formulations EL and EN had a cleaning efficacy of nearly 100%.

Further, formulations EA and BG were identical following the indicated dilutions (i.e., 10:1 and 5:1, respectively), with the exception that formulation EA was devoid of passivating agent. The results suggest that passivating agent, in this case TAZ, not only acts as an effective metal passivator, but also enhances the cleaning of the post-CMP residue and contaminants.

## Example 20

The efficacy of formulations EA and BG for cleaning post-CMP residue and contaminants from a microelectronic device containing same thereon was evaluated. The device was a patterned Sematech 854 wafer which had dried CMP slurry and other post-CMP residues on the surface. The wafer in each instance was cleaned on a spin/spray tool for 1 minute at 22°C at 100 rpm with the specific cleaning composition diluted x:1 (1 part cleaning composition to x parts deionized water), followed by a 30 second deionized water rinse and spin dry. Pre- and post-cleaning analysis was carried out using a Joule scanning electron microscope (SEM). The cleaning efficacy was rated by the reduction of objects on the substrate as described hereinabove and was calculated using equation (1).

Table 9 includes the post-CMP cleaning efficacy results for compositions EA and BG described hereinabove at the indicated dilutions.

Table 9: Post-CMP residue and contaminant cleaning efficacy of the compositions of the present invention.

| Formulation | Dilution | Cleaning Efficacy/% |
|---|---|---|
| EA | 30:1 | 80 |
| BG | 30:1 | 98 |
| BG | 10:1 | 98 |

Importantly, Example 20 demonstrates that the effective formulations may be substantially diluted without compromising the cleaning efficacy of the cleaning composition. This has the benefit of reducing the cost of ownership per wafer cleaned.

## Example 21

The efficacy of formulations EA, BG, EJ and EK for cleaning post-CMP residue and contaminants from a microelectronic device containing same thereon was evaluated. The device was a patterned Sematech 854 wafer which had dried CMP slurry and other post-CMP residues on the surface. The wafer in each instance was cleaned on a spin/spray tool for 1 minute at 22°C at 100 rpm with the specific cleaning composition diluted x:1 (1 part cleaning composition to x parts deionized water), followed by a 30 second deionized water rinse and spin dry. Post-cleaning analysis was carried out using a Nanoscope IIIa atomic force microscope (AFM). The cleaning efficacy was rated by the reduction of objects on the substrate as described hereinabove and was calculated using equation (1).

Table 10 includes the post-CMP cleaning particle count results for compositions EA, BG, EJ and EK described hereinabove at the indicated dilutions.

Table 10: Post-CMP residue cleaning efficacy using the compositions of the present invention.

| Formulation | Dilution | Particle Count |
|---|---|---|
| EA | 30:1 | 2104 |
| BG | 30:1 | 217 |
| BG | 5:1 | 158 |
| EJ | 30:1 | 1546 |
| EK | 10:1 | 270 |

Example 21 further illustrates that the alkaline aqueous cleaning compositions of the invention preferably include a passivating agent such as TAZ, as indicated by the lower particle counts associated with cleaning with formulations BG and EK.

## Example 22

The efficacy of formulations EH and EI for passivating copper on the microelectronic device having same thereon was evaluated. The sample wafer included a copper seed layer. The wafer in each instance was cleaned on a spin/spray tool for 1 minute at 22°C at 100 rpm with cleaning compositions diluted 30:1 (1 part cleaning composition to 30 parts deionized water), followed by a 30 second deionized water rinse and spin dry. A static 10 ppm BTA treatment and an untreated sample were analyzed for comparison. Analysis was done using XPS at angles of 15° to 90°. Table 11 includes the copper passivation results for formulations EH and EI relative to the static BTA and untreated sample.

Table 11: Copper passivation using the compositions of the present invention.

| Formulation | XPS Angle | Copper | Nitrogen | N/Cu |
|---|---|---|---|---|
| Untreated | 15° | 95.4 | 4.6 | 0.048 |
| | 90° | 98.5 | 1.5 | 0.015 |
| BTA | 15° | 32.6 | 67.4 | 2.07 |
| | 90° | 63.3 | 36.7 | 0.58 |
| EH | 15° | 82.6 | 17.4 | 0.21 |
| | 90° | 89.3 | 10.7 | 0.12 |
| EI | 15° | 33.3 | 66.7 | 2 |
| | 90° | 57.1 | 42.9 | 0.75 |

The nitrogen to copper ratio indicates the amount of BTA or other passivating agent (i.e., azole) remaining on the copper following contact of the formulation with the wafer surface. As expected, the static BTA formulation and formulation J, which includes BTA, left a thick layer of BTA on the wafer surface. Formulation EH, which includes TAZ, left a thin passivating layer on the surface of the wafer, which is advantageous because thinner passivating films are easier to remove in subsequent process steps and result in fewer organic defects.

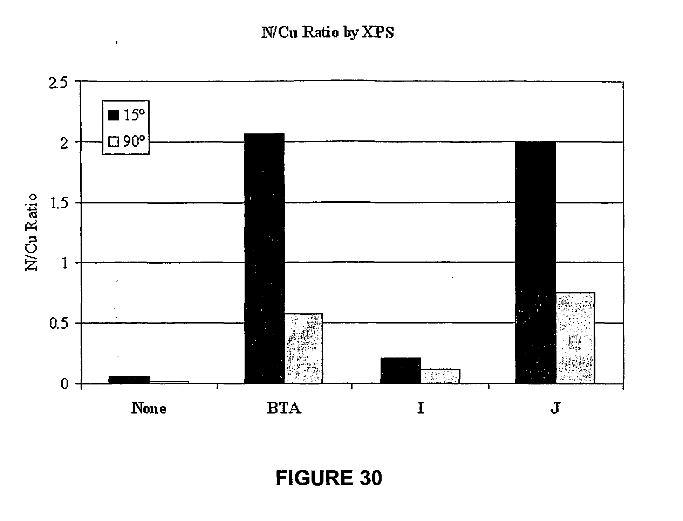

The results of Table 11 are further illustrated in Figure 30.

**Example 23**

The etch rate of cobalt in the presence of formulations EA, BG, EF, EL, EN, and EO was tested compared to a typical industry citrate-based cleaner (10 wt. % diammonium citrate in water). The wafer samples had 100 Å of cobalt plated on polished copper. The wafers were immersed into the formulations at an agitation of 700 rpm. The samples remained in solution until the cobalt was completely removed, which was judged visually by differentiating the color between copper and cobalt.

Table 12: Cobalt etch using compositions of the present invention

| Formulation | Dilution | Immersion Time (min) | Approximate Etch Rate (Å/min) |
|---|---|---|---|
| EA | 40:1 | 22 | 4.5 |
| BG | 20:1 | >1080* | <0.09* |
| EF | 20:1 | >1080* | <0.09* |
| EL | 20:1 | >1080* | <0.09* |
| EN | 20:1 | 45 | 2.2 |
| EO | 20:1 | 41 | 2.4 |
| citrate solution | 40:1 | 5 | 20 |
| * The samples were removed after 1080 min, even though the cobalt still remains on the sample. | | | |

It can be seen that the diammonium citrate cleaner had the largest etch rate on cobalt, and that the formulations of the present invention are a vast improvement over the traditional citrate-based cleaner. Further, comparing formulations EA and BG, the addition of the passivator to the composition decreases the cobalt etch rate to less than 0.5 A min$^{-1}$.

### Example 24

The buff cleaning efficacy was tested using formulations EA and BG for post-CMP residue and contaminants. The wafer samples were blanketed copper wafers previously polished with a CMP slurry. The wafer in each instance was cleaned/buffed on the third platen of an Applied Materials Reflexion ™ tool for 15 seconds at 22°C using variable speeds and 1 psi downforce with the specific cleaning composition diluted x:1 (1 part cleaning composition to x parts deionized water), followed by a standard post-CMP cleaning process for the Reflexion™ tool. Post polish and cleaning analysis was carried out using a KLA-SP1 surface defect analysis instrument having a defect bin size setting of 0.2 $\mu$m. Table 13 includes the defect density results for compositions EA and BG described hereinabove at the indicated platen speeds.

Table 13: Buff cleans using formulations of the present invention at various platen speeds

| Formulation | Dilution | Platen Speed (rpm) | Average defect density (defect/cm$^2$) |
|---|---|---|---|
| EA | 10:1 | 63 | 3.9 |
| EA | 10:1 | 107 | 2.4 |
| BG | 5:1 | 63 | 2.9 |
| BG | 5:1 | 107 | 1.6 |

It can be seen that Formulation BG, which includes the passivating agent, lowers the defect density under identical conditions compared to composition EA.

### Example 25

The buff cleaning efficacy was tested using formulations EA and BG for post-CMP residue and contaminants. The wafer samples were blanketed copper wafers previously polished with a CMP slurry. The wafer in each instance was cleaned/buffed on the third platen of an Applied Materials Reflexion ™ tool for 15 seconds at 22°C at a platen speed of 107 rpm and variable downforce with the cleaning compositions with the specific cleaning composition diluted x:1 (1 part cleaning composition to x parts deionized water), followed by a standard post-CMP cleaning process for the Reflexion™ tool. Post polish and cleaning analysis was carried out using a KLA-SP1 surface defect analysis instrument having a defect bin size setting of 0.2 $\mu$m. Table 14 includes the defect density results for compositions EA and BG described hereinabove at the indicated downforce.

Table 14: Buff cleans using formulations of the present invention at various down force pressures

| Formulation | Dilution | Downforce (psi) | Defect Density (defects/cm$^2$) |
|---|---|---|---|
| EA | 10:1 | 0 | 4.4 |
| EA | 10:1 | 1 | 2.2 |
| EA | 10:1 | 1 | 2.5 |
| EA | 10:1 | 2 | 3.5 |
| BG | 5:1 | 0 | 3 |
| BG | 5:1 | 1 | 1.1 |
| BG | 5:1 | 1 | 1.4 |
| BG | 5:1 | 2 | 0.6 |

It can be seen that Formulation BG, which includes the passivating agent, lowers the defect density under identical conditions compared to composition EA.

Although the invention has been variously disclosed herein with reference to illustrative embodiments and features, it will be appreciated that the embodiments and features described hereinabove are not intended to limit the invention, and that other variations, modifications and other embodiments will suggest themselves to those of ordinary skill in the art, based on the disclosure herein. The invention therefore is to be broadly construed, as encompassing all such variations, modifications and alternative embodiments within the spirit and scope of the claims hereafter set forth.

**Claims**

1. An alkaline aqueous cleaning composition, comprising 0.001 wt% to 25 wt% of at least one amine, 0.001 wt% to 5 wt% of at least one passivating agent, 0.001 wt% to 25 wt% of at least one quaternary base, optionally 0 wt% to 20 wt% of at least one reducing agent, based on the total weight of the composition, and water, wherein said alkaline aqueous cleaning composition is suitable for cleaning post-chemical mechanical polishing (CMP) residue and contaminants from a microelectronic device having said residue and contaminants thereon, wherein the at least one passivating agent comprises a species selected from the group consisting of 1,2,4-triazole (TAZ), tolyltriazole, 3-amino-5-mercapto-1,2,4-triazole, 1-amino-1,2,4-triazole, 1-amino-1,2,3-triazole, 1-amino-5-methyl-1,2,3-triazole, 3-amino-1,2,4-triazole, 3-mercapto-1,2,4-triazole, 3-isopropyl-1,2,4-triazole, carboxybenzotriazole, naphthotriazole, 2-mercaptobenzimidazole (MBI), 2-mercaptobenzothiazole, 4-methyl-2-phenylimidazole, 2-mercaptothiazoline, 5-aminotetrazole (ATA), 5-amino-1,3,4-thiadiazole-2-thiol, 2,4-diamino-6-methyl-1,3,5-triazine, thiazole, triazine, methyltetrazole, 1,3-dimethyl-2-imidazolidinone, 1,5-pentamethylenetetrazole, 1-phenyl-5-mercaptotetrazole, diaminomethyltriazine, imidazoline thione, 4-methyl-4H-1,2,4-triazole-3-thiol, 5-amino-1,3,4-thiadiazole-2-thiol, benzothiazole, tritolyl phosphate, imidazole, indiazole, benzoic acid, ammonium benzoate, and combinations thereof; and

   wherein the at least one amine comprises an amine compound selected from the group consisting of monoethanolamine, N-methylethanolamine (NMEA), aminoethylethanolamine, N-methylaminoethanol, 1-amino-2-propanol, aminoethoxyethanol, diethanolamine, monoisopropanolamine, isobutanolamine, $C_2$-$C_8$ alkanolamines, triethylenediamine, and combinations thereof.

2. The alkaline aqueous cleaning composition of claim 1, comprising the at least one reducing agent, wherein the at least one reducing agent comprises ascorbic acid.

3. The alkaline aqueous cleaning composition of claim 1, wherein the at least one passivating agent is present in an amount effective for a copper static etch rate of about 0.5 Å min$^{-1}$ to about 10 Å min$^{-1}$.

4. The alkaline aqueous cleaning composition of claim 1, further comprising at least one additional reducing agent, wherein the at least one additional reducing agent comprises an acid selected from the group consisting of isoascorbic acid, ascorbic acid derivatives, gallic acid, and combinations thereof

5. The alkaline aqueous cleaning composition of claim 1, further comprising a tertiary amine selected from the group consisting of triethanolamine, methyldiethanolamine, triethylamine, N,N-dimethylglycolamine, N,N-dimethyldiglycolamine, and pentamethyldiethylenetriamine.

6. The alkaline aqueous cleaning composition of claim 1, wherein the at least one quaternary base comprises (NR$^1$R$^2$R$^3$R$^4$)OH, where R$^1$, R$^2$, R$^3$ and R$^4$ may be the same as or different from one another and each is independently selected from the group consisting of hydrogen, $C_1$-$C_{10}$ alkyl groups, and aryl groups.

7. The alkaline aqueous cleaning composition of claim 1, further comprising at least one surfactant.

8. The alkaline aqueous cleaning composition of claim 1, having a pH in a range from about 9 to about 12.

9. The alkaline aqueous cleaning composition of claim 1, further comprising post-CMP residue, wherein the post-CMP residue comprises material selected from the group consisting of particles from a CMP polishing slurry, carbon-rich particles, polishing pad particles, brush deloading particles, equipment materials of construction particles, copper, copper oxides, and materials that are the by-products of the CMP process.

10. The alkaline aqueous cleaning composition of claim 1, selected from the group consisting of Formulations BB-BG, BJ, BL, BN-BZ, CB, CE, CG, and CI, wherein all percentages are by weight, based on the total weight of the formulation:

    Formulation BB MEA 7.2%, TMAH 4%, ascorbic acid 1.6%, TAZ 1%, gallic acid 2.8%, EDTA 0.01%, DI water 83.4%
    Formulation BC MEA 7.2%, TMAH 4%, ascorbic acid 1.6%, TAZ 3%, gallic acid 2.8%, EDTA 0.01 %, DI water 81.4%
    Formulation BD MEA 7.2%, TMAH 4%, ascorbic acid 1.6%, TAZ 5%, gallic acid 2.8%, EDTA 0.01 %, DI water 74.4%, pH 10.3

Formulation BE MEA 8.8%, TMAH 4.9%, ascorbic acid 3.43%, TAZ 1.96%, DI water 80.91 %

Formulation BF MEA 4.5%, TMAH 2.5%, ascorbic acid 1.75%, TAZ 1%, DI water 90.25%, pH 11.4

Formulation BG MEA 4.5%, TMAH 2.5%, ascorbic acid 1%, gallic acid 1.75%, TAZ 1%, DI water 89.25%, pH 10.8

Formulation BJ MEA 7.2%, TMAH 4%, ascorbic acid 1.6%, gallic acid 2.8%, carboxy BTA 2.2%, EDTA 0.01%, DI water 82.8%

Formulation BL MEA 7.2%, TMAH 4%, ascorbic acid 1.6%, gallic acid 2.8%, ATA 1.2%, EDTA 0.01 %, DI water 83.2%

Formulation BN MEA 9%, TMAH 2.5%, ascorbic acid 3.5%, TAZ 1.0%, DI water 84.0%

Formulation BO MEA 4.5%, TMAH 2.5%, ascorbic acid 1.75%, TAZ 5.0%, DI water 86.25%

Formulation BP MEA 9%, TMAH 2.5%, ascorbic acid 3.5%, TAZ 5.0%, DI water 80.0%

Formulation BQ MEA 9%, TMAH 5%, ascorbic acid 3.5%, TAZ 2.0%, DI water 81.5%,pH 11.6

Formulation BR MEA 9%, TMAH 5%, ascorbic acid 2%, gallic acid 3.5%, TAZ 2%, DDBSA 0.11%, DI water 78.39%

Formulation BS MEA 9%, TMAH 5%, ascorbic acid 2%, gallic acid 3.5%, TAZ 2%, hydroxyethylcellulose 0.1%, DI water 78.4%

Formulation BT MEA 9%, TMAH 5%, ascorbic acid 3.5%, TAZ 2%, hydroxyethylcellulose 0.1%, DI water 80.4%

Formulation BU MEA 9%, TMAH 5%, ascorbic acid 3.5%, TAZ 2%, hydroxypropylcellulose 0.1%, DI water 80.4%

Formulation BV MEA 8.82%, TMAH 4.9%, ascorbic acid 3.43%, TAZ 1.96%, hydroxyethylcellulose 1.00%, DI water 79.89%

Formulation BW MEA 8.82%, TMAH 4.9%, ascorbic acid 3.43%, TAZ 1.96%, hydroxyethylcellulose 0.50%, DI water 80.39%

Formulation BX MEA 8.82%, TMAH 4.9%, ascorbic acid 3.43%, TAZ 1.96%, hydroxypropylcellulose 1.00%, DI water 79.89%

Formulation BY MEA 8.82%, TMAH 4.9%, ascorbic acid 3.43%, TAZ 1.96%, hydroxypropylcellulose 0.50%, DI water 80.39%

Formulation BZ MEA 10.29%, TMAH 5.71%, ascorbic acid 4.00%, TAZ 2.29%, hydroxypropylcellulose 1.14%, DI water 76.57%

Formulation CB MEA 8.82%, TMAH 4.9%, ascorbic acid 3.43%, TAZ 1.96%, dodecylbenzenesulfonic acid 0.11%, DI water 80.78%, pH 12.0

Formulation CE 9 wt. % Monoethanolamine, 5 wt. % Tetramethylammonium hydroxide, 3.5 wt. % Gallic Acid, 2% 1,2,4-Triazole, 80.5 wt. % $H_2O$

Formulation CG 11 wt. % 1-Amino-2-propanol, 5 wt. % Tetramethylammonium hydroxide, 3.5 wt. % Gallic Acid, 2 wt. % Ascorbic Acid, 2% 1,2,4-Triazole, 76.5 wt. % $H_2O$

Formulation CI 7.2 wt. % Monoethanolamine, 4 wt. % Tetramethylammonium hydroxide, 2.8 wt. % Gallic Acid, 1.6 wt. % Ascorbic Acid, 2% 1,2,4-Triazole, 82.4 wt. % $H_2O$

11. A kit comprising, in one or more containers, one or more of the following reagents for forming an alkaline aqueous cleaning composition, said one or more reagents selected from the group consisting of at least one amine, at least one passivating agent, at least one quaternary base, optionally at least one additional reducing agent, and water, and wherein the kit is adapted to form the alkaline aqueous cleaning composition of claim 1.

12. A method of cleaning residue and contaminants from a microelectronic device having said residue and contaminants thereon, said method comprising contacting the microelectronic device with an alkaline aqueous cleaning composition of claim 1 for sufficient time to at least partially clean said residue and contaminants from the microelectronic device.

13. The method of claim 12, wherein said residue and contaminants comprise post-CMP residue and contaminants selected from the group consisting of particles from a CMP polishing slurry, chemicals present in the CMP polishing slurry, reaction by-products of the CMP polishing slurry, carbon-rich particles, polishing pad particles, brush deloading particles, equipment materials of construction particles, copper, copper oxides, and cobalt.

14. The method of claim 12, wherein said contacting comprises conditions selected from the group consisting of: time of from about 15 seconds to about 5 minutes; temperature in a range of from about 20°C to about 50°C; and combinations thereof.

15. The method of claim 12, wherein the alkaline aqueous cleaning composition comprises at least one reducing agent, wherein the at least one reducing agent comprises ascorbic acid.

16. The method of claim 12, wherein the at least one quaternary base comprises $(NR^1R^2R^3R^4)OH$ where $R^1$, $R^2$, $R^3$ and $R^4$ may be the same as or different from one another and each is independently selected from the group consisting of hydrogen, $C_1$-$C_{10}$ alkyl groups, and aryl groups.

17. The method of claim 12, wherein the alkaline aqueous removal composition further comprises at least one additional reducing agent, wherein the at least one additional reducing agent comprises an acid selected from the group consisting of isoascorbic acid, ascorbic acid derivatives, gallic acid, and combinations thereof.

**Patentansprüche**

1. Alkalische wässrige Reinigungszusammensetzung, umfassend 0,001 Gew.% bis 25 Gew.% mindestens eines Amins, 0,001 Gew.% bis 5 Gew.% mindestens eines Passivierungsmittels, 0,001 Gew.% bis 25 Gew.% mindestens einer quaternären Base, wahlweise 0 Gew.% bis 20 Gew.% mindestens eines Reduktionsmittels, bezogen auf das Gesamtgewicht der Zusammensetzung, und Wasser, worin die alkalische wässrige Reinigungszusammensetzung zur Reinigung nach dem chemisch-mechanischen Polieren (CMP) von Rückstände und Kontaminationen auf mikroelektronischen Vorrichtung, mit Rückstand und Verunreinigungen darauf, geeignet ist, worin mindestens ein Passivierungsmittel eine Klasse enthält ausgewählt aus der Gruppe bestehend aus 1,2,4-Triazol (TAZ), Tolyltriazol, 3-Amino-5-mercapto-1,2,4-triazol, 1-Amino-1,2,4-triazol, 1-Amino-1,2,3-triazol, 1-Amino-5-methyl-1,2,3-triazol, 3-Amino-1,2,4-triazol, 3-Mercapto-1,2,4-triazol, 3-Isopropyl-1,2,4-triazol, Carboxybenzotriazol, Naphthotriazol, 2-Mercaptobenzimidazol (MBI), 2-Mercaptobenzothiazol, 4-Methyl-2-phenylimidazol, 2-Mercaptothiazolin, 5-Aminotetrazol (ATA), 5-Amino-1,3,4-thiadiazol-2-thiol, 2,4-Diamino-6-methyl-1,3,5-triazin, Thiazol, Triazin, Methyltetrazol, 1,3-Dimethyl-2-imidazolidinon, 1,5-Pentamethylentetrazol, 1-Phenyl-5-mercaptotetrazol, Diaminomethyltriazin, Imidazolinthion, 4-Methyl-4H-1,2,4-triazol-3-thiol, 5-Amino-1,3,4-thiadiazol-2-thiol, Benzothiazol, Tritolylphosphat, Imidazol, Indiazol, Benzoesäure, Ammoniumbenzoat und Kombinationen davon, und
wobei mindestens ein Amin eine Amin-Verbindung enthält ausgewählt aus der Gruppe bestehend aus Monoethanolamin, N-Methylethanolamin (NMEA), Aminoethylethanolamin, N-Methylaminoethanol, 1-Amino-2-propanol, Aminoethoxyethanol, Diethanolamin, Monoisopropanolamin, Isobutanolamin, $C_2$-$C_8$-Alkanolamine, Triethylendiamin und Kombinationen davon.

2. Die alkalische wässrige Reinigungszusammensetzung nach Anspruch 1, umfassend mindestens ein Reduktionsmittel, worin das mindestens eine Reduktionsmittel Ascorbinsäure enthält.

3. Die alkalische wässrige Reinigungszusammensetzung nach Anspruch 1, worin mindestens ein Passivierungsmittel in einer Menge vorliegt, die wirksam ist für eine statische Ätzgeschwindigkeit von Kupfer von ungefähr 0,5 Å min$^{-1}$ bis ungefähr 10 Å min$^{-1}$.

4. Die alkalische wässrige Reinigungszusammensetzung nach Anspruch 1, ferner umfassend mindestens ein zusätzliches Reduktionsmittel, worin das mindestens eine zusätzliche Reduktionsmittel eine Säure umfasst ausgewählt aus der Gruppe bestehend aus Isoascorbinsäure, Ascorbinsäurederivaten, Gallussäure und Kombinationen davon.

5. Die alkalische wässrige Reinigungszusammensetzung nach Anspruch 1, ferner umfassend ein tertiäres Amin ausgewählt aus der Gruppe bestehend aus Triethanolamin, Methyldiethanolamin, Triethylamin, N,N-Dimethylglykolamin, N,N-Dimethyldiglykolamin und Pentamethyldiethylentriamin.

6. Die alkalische wässrige Reinigungszusammensetzung nach Anspruch 1, worin die mindestens eine quaternäre Base $(NR^1R^2R^3R^4)OH$ umfasst, wobei $R^1$, $R^2$, $R^3$ und $R^4$ gleich oder unterschiedlich voneinander sind und je unabhängig voneinander ausgewählt sind aus der Gruppe bestehend aus Wasserstoff, $C_1$-$C_{10}$-Alkyl-Gruppen und Aryl-Gruppen.

7. Die alkalische wässrige Reinigungszusammensetzung nach Anspruch 1, ferner umfassend mindestens ein Tensid.

8. Die alkalische wässrige Reinigungszusammensetzung nach Anspruch 1, mit einem pH im Bereich von ungefähr 9 bis ungefähr 12.

9. Die alkalische wässrige Reinigungszusammensetzung nach Anspruch 1, ferner umfassend einen nach-CMP-Rückstand, worin der nach-CMP-Rückstand einen Stoff umfasst ausgewählt aus der Gruppe bestehend aus Partikeln von einer CMP-Poliersuspension, kohlenstoffreichen Partikeln, Polierkissenteilchen, Ablagungspartikel der Bürsten, Betriebsmittelmaterialien der Aufbaupartikel, Kupfer, Kupferoxid und Materialen die Nebenprodukte des CMP-Verfahrens sind.

10. Die alkalische wässrige Reinigungszusammensetzung nach Anspruch 1, ausgewählt aus der Gruppe bestehend aus den Formulierungen BB-BG, BJ, BL, BN-BZ, CB, CE, CG und CI, worin sich alle Prozentsätze auf das Gewicht beziehen, basierend auf dem Gesamtgewicht der Formulierung:

Formulierung BB: MEA 7,2 %, ,TMAH 4 %, Ascorbinsäure 1,6 %, TAZ 1 %, Gallussäure 2,8 %, EDTA 0,01 %, deionisiertes Wasser 83,4 %

Formulierung BC: MEA 7,2 %, TMAH 4 %, Ascorbinsäure 1,6 %, TAZ 3 %, Gallussäure 2,8 %, EDTA 0,01 %, deionisiertes Wasser 81,4 %

Formulierung BD: MEA 7,2 %, TMAH 4 %, Ascorbinsäure 1,6 %, TAZ 5 %, Gallussäure 2,8 %, EDTA 0,01 %, deionisiertes Wasser 74,4 %, pH 10,3

Formulierung BE: MEA 8,8 %, TMAH 4,9 %, Ascorbinsäure 3,43 %, TAZ 1,96 %, deionisiertes Wasser 80,91 %

Formulierung BF: MEA 4,5 %, TMAH 2,5 %, Ascorbinsäure 1,75 %, TAZ 1 %, deionisiertes Wasser 90,25 %, pH 11,4

Formulierung BG: MEA 4,5 %, TMAH 2,5 %, Ascorbinsäure 1 %, Gallussäure 1,75 %, TAZ 1 %, deionisiertes Wasser 89,25 %, pH 10,8

Formulierung BJ: MEA 7,2 %, TMAH 4 %, Ascorbinsäure 1,6 %, Gallussäure 2,8 %, Carboxyl-BTA 2,2 %, EDTA 0,01 %, deionisiertes Wasser 82,8 %

Formulierung BL: MEA 7,2 %, TMAH 4 %, Ascorbinsäure 1,6 %, Gallussäure 2,8 %, ATA 1,2 %, EDTA 0,01 %, deionisiertes Wasser 83,2 %

Formulierung BN: MEA 9 %, TMAH 2,5 %, Ascorbinsäure 3,5 %, TAZ 1,0 %, deionisiertes Wasser 84,0 %

Formulierung BO: MEA 4,5 %, TMAH 2,5 %, Ascorbinsäure 1,75 %, TAZ 5,0 %, deionisiertes Wasser 86,25 %

Formulierung BP: MEA 9 %, TMAH 2,5 %, Ascorbinsäure 3,5 %, TAZ 5,0 %, deionisiertes Wasser 80,0 %

Formulierung BQ: MEA 9 %, TMAH 5 %, Ascorbinsäure 3,5 %, TAZ 2,0 %, deionisiertes Wasser 81,5 %, pH 11,6

Formulierung BR: MEA 9 %, TMAH 5 %, Ascorbinsäure 2 %, Gallussäure 3,5 %, TAZ 2 %, DDBSA 0,11 %, deionisiertes Wasser 78,39 %

Formulierung BS: MEA 9 %, TMAH 5 %, Ascorbinsäure 2 %, Gallussäure 3,5 %, TAZ 2 %, Hydroxyethylcellulose 0,1 %, deionisietes Wasser 78,4 %

Formulierung BT: MEA 9 %, TMAH 5 %, Ascorbinsäure 3,5 %, TAZ 2 %, Hydroxyethylcellulose 0,1 %, deionisiertes Wasser 80,4 %

Formulierung BU: MEA 9 %, TMAH 5 %, Ascorbinsäure 3,5 %, TAZ 2 %, Hydroxypropylcellulose 0,1 %, deionisieretes Wasser 80,4 %

Formulierung BV: MEA 8,82 %, TMAH 4,9 %, Ascorbinsäure 3,43 %, TAZ 1,96 %, Hydroxyethylcellulose 1,00 %, deionisiertes Wasser 79,89 %

Formulierung BW: MEA 8,82 %, TMAH 4,9 %, Ascorbinsäure 3,43 %, TAZ 1,96 %, Hydroxyethylcellulose 0,50 %, deionisiertes Wasser 80,39 %

Formulierung BX: MEA 8,82 %, TMAH 4,9 %, Ascorbinsäure 3,43 %, TAZ 1,96 %, Hydroxypropylcellulose 1,00 %, deionisiertes Wasser 79,89 %

Formulierung BY: MEA 8,82 %, TMAH 4,9 %, Ascorbinsäure 3,43 %, TAZ 1,96 %, Hydroxypropylcellulose 0,50 %, deionisiertes Wasser 80,39 %

Formulierung BZ: MEA 10,29 %, TMAH 5,71 %, Ascorbinsäure 4,00 %, TAZ 2,29 %, Hydroxypropylcellulose 1,14 %, deionisiertes Wasser 76,57 %

Formulierung CB: MEA 8,82 %, TMAH 4,9 %, Ascorbinsäure 3,43 %, TAZ 1,96 %, Dodecylbenzensulfonsäure 0,11 %, deionisiertes Wasser 80,78 %, pH 12,0

Formulierung CE: 9 Gew.% Monoethanolamin, 5 Gew.% Tetramethylammoniumhydroxyid, 3,5 Gew.% Gallussäure, 2 % 1,2,4-Triazol, 80,5 Gew.% $H_2O$

Formulierung CG: 11 Gew.% 1-Amino-2-propanol, 5 Gew.% Tetramethylammoniumhydroxid, 3,5 Gew.% Gallussäure, 2 Gew.% Ascorbinsäure, 2 % 1,2,4-Triazol, 76,5 Gew.% $H_2O$

Formulierung CI: 7,2 Gew.% Monoethanolamin, 4 Gew.% Tetramethylammoniumhydroxid, 2,8 Gew.% Gallussäure, 1,6 Gew.% Ascorbinsäure, 2 % 1,2,4-Triazol, 82,4 Gew.% $H_2O$

11. Ein Kit umfassend, in einem oder mehreren Behältern, eine oder mehrere der folgenden Reagenzien zur Bildung einer alkalischen wässrigen Reinigungszusammensetzung, diese eine oder mehreren Reagenzien sind ausgewählt aus der Gruppe bestehend aus mindestens einem Amin, mindestens einem Passivierungsmittel, mindestens einer quaternäre Base, wahlweise mindestens einem zusätzlichen Reduktionsmittel und Wasser, wobei das Kit geeignet ist eine alkalische wässrige Reinigungszusammensetzung nach Anspruch 1 zu bilden.

**12.** Ein Verfahren zur Reinigung von Rückständen und Verunreinigungen von einer mikroelektronischen Vorrichtung mit diesen Rückstände und Verunreinigungen darauf, dieses Verfahren umfasst das in Kontakt bringen der mikroelektronischen Vorrichtung mit einer alkalischen wässrigen Reinigungszusammensetzung nach Anspruch 1 für eine ausreichende Zeit, um diese Rückstände und Verunreinigungen mindestens teilweise von der mikroelektronischen Vorrichtung zu reinigen.

**13.** Das Verfahren nach Anspruch 12, worin die Rückstände und Verunreinigungen nach-CMP-Rückstände und Verunreinigungen, ausgewählt aus der Gruppe bestehend aus Partikeln von einer CMP-Poliersuspension, Chemikalien, die in der CMP-Poliersuspension enthalten sind, Nebenprodukte der Reaktion der CMP-Poliersuspension, kohlenstoffreiche Partikeln, Polierkissenteilchen, Ablagungspartikel der Bürsten, Betriebsmittelmaterialien der Aufbaupartikel, Kupfer, Kupferoxid und Kobalt, umfassen.

**14.** Das Verfahren nach Anspruch 12, worin das in Kontakt bringen Bedingungen umfasst ausgewählt aus der Gruppe bestehend aus: Zeit von ungefähr 15 Sekunden bis ungefähr 5 Minuten, Temperatur in einem Bereich von ungefähr 20 °C bis ungefähr 50 °C und Kombinationen davon.

**15.** Das Verfahren nach Anspruch 12, worin die alkalische wässrige Reinigungszusammensetzung mindestens ein Reduktionsmittel umfasst, worin das mindestens eine Reduktionsmittel eine Ascorbinsäure enthält.

**16.** Das Verfahren nach Anspruch 12, worin die mindestens eine quaternäre Base $(NR^1R^2R^3R^4)OH$ umfasst, wobei $R^1$, $R^2$, $R^3$ und $R^4$ gleich oder unterschiedlich voneinander sind und je unabhängig voneinander ausgewählt sind aus der Gruppe bestehend aus Wasserstoff, $C_1$-$C_{10}$-Alkyl-Gruppen und Aryl-Gruppen.

**17.** Das Verfahren nach Anspruch 12, worin die alkalische wässrige Entfernungszusammensetzung ferner mindestens ein zusätzliches Reduktionsmittel umfasst, worin das mindestens eine zusätzliche Reduktionsmittel eine Säure umfasst, ausgewählt aus der Gruppe bestehend aus Isoascorbinsäure, Ascorbinsäurederivaten, Gallussäure und Kombinationen davon.

**Revendications**

**1.** Composition aqueuse alcaline de nettoyage, comprenant de 0,001 % en poids à 25 % en poids d'au moins une amine, de 0,001 % en poids à 5 % en poids d'au moins un agent de passivation, de 0,001 % en poids à 25 % en poids d'au moins une base quaternaire, facultativement de 0 % en poids à 20 % en poids d'au moins un agent réducteur, sur la base du poids total de la composition, et de l'eau, dans laquelle ladite composition aqueuse alcaline de nettoyage est appropriée pour nettoyer des résidus de post-polissage chimico-mécanique (PMC) et des contaminants issus d'un dispositif microélectronique comportant lesdits résidus et contaminants, dans laquelle au moins un agent de passivation comprend une espèce sélectionnée dans le groupe constitué par le 1,2,4-triazole (TAZ), le tolyltriazole, le 3-amino-5-mercapto-1,2,4-triazole, le 1-amino-1,2,4-triazole, le 1-amino-1,2,3-triazole, le 1-amino-5-méthyl-1,2,3-triazole, le 3-amino-1,2,4-triazole, le 3-mercapto-1,2,4-triazole, le 3-isopropyl-1,2,4-triazole, le carboxybenzotriazole, le naphtotriazole, le 2-mercaptobenzimidazole (MBI), le 2-mercaptobenzothiazole, le 4-méthyl-2-phénylimidazole, la 2-mercaptothiazoline, le 5-aminotétrazole (ATA), le 5-amino-1,3,4-thiadiazole-2-thiol, la 2,4-diamino-6-méthyl-1,3,5-triazine, le thiazole, la triazine, le méthyltétrazole, la 1,3-diméthyl-2-imidazolidinone, le 1,5-pentaméthylènetétrazole, le 1-phényl-5-mercaptotétrazole, la diaminométhyltriazine, l'imidazoline thione, le 4-méthyl-4H-1,2,4-triazole-3-thiol, le 5-amino-1,3,4-thiadiazole-2-thiol, le benzothiazole, le phosphate de tritolyle, l'imidazole, l'indiazole, l'acide benzoïque, le benzoate d'ammonium et les combinaisons de ceux-ci ; et dans laquelle l'au moins une amine comprend un composé aminé sélectionné dans le groupe constitué par la monoéthanolamine, la N-méthyl éthanolamine (NMEA), l'aminoéthyl éthanolamine, le N-méthyl aminoéthanol, le 1-amino-2-propanol, l'amino éthoxy éthanol, la diéthanolamine, la monoisopropanolamine, l'isobutanolamine, les alcanolamines en $C_2$ à $C_8$, la triéthylènediamine et les combinaisons de ceux-ci.

**2.** Composition aqueuse alcaline de nettoyage selon la revendication 1, comprenant l'au moins un agent réducteur, dans laquelle l'au moins un agent réducteur comprend de l'acide ascorbique.

**3.** Composition aqueuse alcaline de nettoyage selon la revendication 1, dans laquelle l'au moins un agent de passivation est présent en une quantité efficace pour un taux de nettoyage de cuivre statique d'environ 0,5 Å min$^{-1}$ à environ 10 Å min$^{-1}$.

**EP 1 888 735 B1**

4. Composition aqueuse alcaline de nettoyage selon la revendication 1, comprenant en outre au moins un agent réducteur supplémentaire, dans laquelle l'au moins un agent de réduction supplémentaire comprend un acide sélectionné dans le groupe constitué par l'acide isoascorbique, les dérivés d'acide ascorbique, l'acide gallique et les combinaisons de ceux-ci.

5. Composition aqueuse alcaline de nettoyage selon la revendication 1, comprenant en outre une amine tertiaire sélectionnée dans le groupe constitué par la triéthanolamine, la méthyldiéthanolamine, la triéthylamine, la N,N-diméthylglycolamine, la N,N-diméthyldiglycolamine et la pentaméthyldiéthylènetriamine.

6. Composition aqueuse alcaline de nettoyage selon la revendication 1, dans laquelle l'au moins une base quaternaire comprend $(NR^1R^2R^3R^4)OH$, où $R^1$, $R^2$, $R^3$ et $R^4$ peuvent être identiques ou différents les uns des autres et chacun est sélectionné indépendamment dans le groupe constitué par l'hydrogène, les groupes alkyle en $C_1$ à $C_{10}$ et les groupes aryle.

7. Composition aqueuse alcaline de nettoyage selon la revendication 1, comprenant en outre au moins un tensioactif.

8. Composition aqueuse alcaline de nettoyage selon la revendication 1, ayant un pH dans une plage allant d'environ 9 à environ 12.

9. Composition aqueuse alcaline de nettoyage selon la revendication 1, comprenant en outre des résidus post-CMP, dans laquelle les résidus post-CMP comprennent un matériau sélectionné dans le groupe constitué par les particules issues d'une boue de polissage CMP, les particules riches en carbone, les particules de tampon de polissage, les particules d'une élimination par brossage, les matériels d'équipement de particules de construction, le cuivre, les oxydes de cuivre et les matières qui sont les sous-produits du procédé CMP.

10. Composition aqueuse alcaline de nettoyage selon la revendication 1, sélectionnée dans le groupe constitué par les formulations BB-BG, BJ, BL, BN-BZ, CB, CE, CG et CI, dans lesquelles tous les pourcentages sont en poids, sur la base du poids total de la formulation :

Formulation BB MEA 7,2 %, TMAH 4 %, acide ascorbique 1,6 %, TAZ 1 %, acide gallique 2,8 %, EDTA 0,01 %, eau désionisée 83,4 %
Formulation BC MEA 7,2 %, TMAH 4 %, acide ascorbique 1,6 %, TAZ 3 %, acide gallique 2,8 %, EDTA 0,01 %, eau désionisée 81,4 %
Formulation BD MEA 7,2 %, TMAH 4 %, acide ascorbique 1,6 %, TAZ 5 %, acide gallique 2,8 %, EDTA 0,01 %, eau désionisée 74,4 %, pH 10,3
Formulation BE MEA 8,8 %, TMAH 4,9 %, acide ascorbique 3,43 %, TAZ 1,96 %, eau désionisée 80,91 %
Formulation BF MEA 4,5 %, TMAH 2,5 %, acide ascorbique 1,75 %, TAZ 1 %, eau désionisée 90,25 %, pH 11,4
Formulation BG MEA 4,5 %, TMAH 2,5 %, acide ascorbique 1 %, acide gallique 1,75 %, TAZ 1 %, eau désionisée 89,25 %, pH 10,8
Formulation BJ MEA 7,2 %, TMAH 4 %, acide ascorbique 1,6 %, acide gallique 2,8 %, carboxy BTA 2,2 %, EDTA 0,01 %, eau désionisée 82,8 %
Formulation BL MEA 7,2 %, TMAH 4 %, acide ascorbique 1,6 %, acide gallique 2,8 %, ATA 1,2 %, EDTA 0,01 %, eau désionisée 83,2 %
Formulation BN MEA 9 %, TMAH 2,5 %, acide ascorbique 3,5 %, TAZ 1,0 %, eau désionisée 84,0 %
Formulation BO MEA 4,5 %, TMAH 2,5 %, acide ascorbique 1,75 %, TAZ 5,0 %, eau désionisée 86,25 %
Formulation BP MEA 9 %, TMAH 2,5 %, acide ascorbique 3,5 %, TAZ 5,0 %, eau désionisée 80,0 %
Formulation BQ MEA 9 %, TMAH 5%, acide ascorbique 3,5%, TAZ 2,0 %, eau désionisée 81,5 %, pH 11,6
Formulation BR MEA 9 %, TMAH 5 %, acide ascorbique 2%, acide gallique 3,5 %, TAZ 2 %, DDBSA 0,11 %, eau désionisée 78,39 %
Formulation BS MEA 9 %, TMAH 5 %, acide ascorbique 2%, acide gallique 3,5 %, TAZ 2 %, hydroxyéthylcellulose 0,1 %, eau désionisée 78,4 %
Formulation BT MEA 9%, TMAH 5 %, acide ascorbique 3,5%, TAZ 2 %, hydroxyéthylcellulose 0,1%, eau désionisée 80,4 %
Formulation BU MEA 9%, TMAH 5 %, acide ascorbique 3,5%, TAZ 2 %, hydroxypropylcellulose 0,1 %, eau désionisée 80,4 %
Formulation BV MEA 8,82%, TMAH 4,9 %, acide ascorbique 3,43 %, TAZ 1,96 %, hydroxyéthylcellulose 1,00 %, eau désionisée 79,89 %
Formulation BW MEA 8,82 %, TMAH 4,9 %, acide ascorbique 3,43 %, TAZ 1,96 %, hydroxyéthylcellulose 0,50

31

%, eau désionisée 80,39 %

Formulation BX MEA 8,82 %, TMAH 4,9 %, acide ascorbique 3,43 %, TAZ 1,96 %, hydroxypropylcellulose 1,00 %, eau désionisée 79,89 %

Formulation BY MEA 8,82 %, TMAH 4,9 %, acide ascorbique 3,43 %, TAZ 1,96 %, hydroxypropylcellulose 0,50 %, eau désionisée 80,39 %

Formulation BZ MEA 10,29 %, TMAH 5,71 %, acide ascorbique 4,00 %, TAZ 2,29 %, hydroxypropylcellulose 1,14 %, eau désionisée 76,57 %

Formulation CB MEA 8,82 %, TMAH 4,9 %, acide ascorbique 3,43 %, TAZ 1,96 %, acide sufonique de dodécylbenzène 0,11%, eau désionisée 80,78 %, pH 12,0

Formulation CE 9 % en poids de monoéthanolamine, 5 % en poids d'hydroxyde de tétraméthylammonium, 3,5 % en poids d'acide gallique, 2 % de 1,2,4-triazole, 80,5 % en poids de $H_2O$

Formulation CG 11% en poids de 1-aminopropan-2-ol, 5 % en poids d'hydroxyde de tétraméthylammonium, 3,5 % en poids d'acide gallique, 2 % en poids d'acide ascorbique, 2 % de 1,2,4-triazole, 76,5 % en poids de $H_2O$

Formulation CI 7,2 % en poids de monoéthanolamine, 4 % en poids d'hydroxyde de tétraméthylammonium, 2,8 % en poids d'acide gallique, 1,6 % en poids d'acide ascorbique, 2 % de 1,2,4-triazole, 82,4 % en poids de $H_2O$

11. Kit comprenant, dans un ou plusieurs contenants, un ou plusieurs des réactifs suivants pour former une composition aqueuse alcaline de nettoyage, ledit ou lesdits réactifs étant sélectionnés dans le groupe constitué par au moins une amine, au moins un agent de passivation, au moins une base quaternaire, facultativement au moins un agent réducteur supplémentaire, et de l'eau, et dans lequel le kit est adapté pour former la composition aqueuse alcaline de nettoyage selon la revendication 1.

12. Procédé de nettoyage de résidus et de contaminants issus d'un dispositif microélectronique comportant lesdits résidus et contaminants, ledit procédé comprenant la mise en contact du dispositif microélectronique avec une composition aqueuse alcaline de nettoyage selon la revendication 1 pendant une durée suffisante pour nettoyer au moins partiellement lesdits résidus ou contaminants issus du dispositif microélectronique.

13. Procédé selon la revendication 12, dans lequel lesdits résidus et contaminants comprennent des résidus et des contaminants post-CMP sélectionnés dans le groupe constitué par les particules issus d'une boue de polissage CMP, les produits chimiques présents dans la boue de polissage CMP, les sous-produits de réaction de la boue de polissage CMP, les particules riches en carbone, les particules de tampon de polissage, les particules d'une élimination par brossage, les matériels d'équipement de particules de construction, le cuivre, les oxydes de cuivre et le cobalt.

14. Procédé selon la revendication 12, dans lequel ladite mise en contact comprend des conditions sélectionnées dans le groupe constitué par : une durée d'environ 15 secondes à environ 5 minutes ; une température dans une plage allant d'environ 20°C à environ 50°C et les combinaisons de celles-ci.

15. Procédé selon la revendication 12, dans lequel la composition de nettoyage aqueuse alcaline comprend au moins un agent réducteur, dans lequel l'au moins un agent réducteur comprend de l'acide ascorbique.

16. Procédé selon la revendication 12, dans lequel l'au moins une base quaternaire comprend $(NR^1R^2R^3R^4)OH$ où $R^1$, $R^2$, $R^3$ et $R^4$ peuvent être identiques ou différents les uns des autres et chacun est sélectionné indépendamment dans le groupe constitué par l'hydrogène, les groupes alkyle en $C_1$ à $C_{10}$ et les groupes aryle.

17. Procédé selon la revendication 12, dans lequel la composition aqueuse alcaline d'élimination comprend en outre au moins un agent réducteur supplémentaire, dans lequel l'au moins un agent réducteur supplémentaire comprend un acide sélectionné dans le groupe constitué par l'acide isoascorbique, les dérivés d'acide ascorbique, l'acide gallique et les combinaisons de ceux-ci.

**FIGURE 1**

**FIGURE 2**

**FIGURE 3A**

**FIGURE 3B**

EP 1 888 735 B1

**FIGURE 4A**

**FIGURE 4B**

**FIGURE 5A**

**FIGURE 5B**

**FIGURE 6**

**FIGURE 7**

**FIGURE 8**

**FIGURE 9**

**FIGURE 10**

**FIGURE 11**

**FIGURE 12**

**FIGURE 13**

**FIGURE 14**

**FIGURE 15**

**FIGURE 16**

**FIGURE 17**

**FIGURE 18**

**FIGURE 19**

44

**FIGURE 20**

**FIGURE 21**

46

**FIGURE 22**

**FIGURE 23**

**FIGURE 24**

**FIGURE 25**

**FIGURE 26**

**FIGURE 27A**

**FIGURE 27B**

before
after

**FIGURE 28**

before
after

**FIGURE 29**

N/Cu Ratio by XPS

FIGURE 30

**EP 1 888 735 B1**

**Patent documents cited in the description**

- US 6558879 B, Peters
- WO 0195381 A2
- US 619436681 B
- WO 02065538 A2